# EUROPÄISCHE PATENTSCHRIFT

(11) **EP 0 823 144 B1**
(45) Veröffentlichungstag und Bekanntmachung des Hinweises auf die Patenterteilung: **08.01.2003**
(21) Anmeldenummer: 96910011.4
(22) Anmeldetag: 23.03.1996
(51) Int. Cl.: H01S 3/23, H01S 5/40, H01S 3/00

(54) **ANORDNUNG ZUR FORMUNG UND FÜHRUNG EINES STRAHLUNGSFELDS EINES ODER MEHRERER FESTKÖRPER- UND/ODER HALBLEITERLASER(S)**
DEVICE FOR FORMING AND GUIDING THE RADIATION FIELD OF ONE OR SEVERAL SOLID SATE AND/OR SEMICONDUCTOR LASERS
DISPOSITIF DE FORMAGE ET DE GUIDAGE DU CHAMP DE RAYONNEMENT D'UN OU PLUSIEURS LASERS SOLIDES ET/OU A SEMI-CONDUCTEUR

(30) Priorität: 26.04.1995 DE 19514625
(43) Veröffentlichungstag der Anmeldung: 11.02.1998
(73) Patentinhaber: Fraunhofer-Gesellschaft zur Förderung der angewandten Forschung e.V., 80636 München (DE)
(72) Erfinder: DU, Keming, D-52078 Aachen (DE); LOOSEN, Peter, D-52076 Kornelimünster (DE)
(74) Vertreter: Grimm, Ekkehard
(86) Internationale Anmeldenummer: EP9601286
(87) Internationale Veröffentlichungsnummer: WO96034441

(56) Entgegenhaltungen:
- EP-A- 0 772 791
- WO-A-95/15510
- WO-A-96/13884
- DE-A- 4 446 026
- US-A- 4 986 634
- CLEO-1994, 28.August 1994 - 2.September 1994, AMSTERDAM, Seiten 410-411, XP002006235 W.A.CLARKSON ET AL.: "DIODE LASER BAR BEAM SHAPING TECHNIQUE"
- OPTICS LETTERS, Bd. 20, Nr. 2, 15.Januar 1995, WASHINGTON US, Seiten 222-224, XP002006236 R.P.EDWIN: "STRIPE STACKER FOR USE WITH LASER DIODE BARS"

## Beschreibung

Die Erfindung betrifft eine Anordnung zur Formung und Führung eines Strahlungsfelds eines oder mehrerer Festkörper- und/oder Halbleiterlaser(s), insbesondere eines Strahlungsfelds eines Arrays bzw. einer Feldanordnung aus mehreren Lasern.

In der WO 96/04584 ist eine optische Anordnung zum Transformieren eines Felds aus Lichtstrahlen beschrieben, die, in Ausbreitungsrichtung der Lichtstrahlen gesehen, ein reflektives und ein refraktives Element aufweist. Der reflektive Element besitzt eine Folge von jeweiligen Reflexionsflächenpaaren. Die beiden Reflexionsflächen dieser Paare sind unter einem Winkel von 90° zueinander orientiert und als Flächen von V-förmigen Nuten in einem Trägerkörper ausgebildet. Weiterhin schneiden sich die Reflexionsflächen jeweiliger benachbarter Nuten entlang einer Kante, wobei die einzelnen Schnittkanten parallel zueinander verlaufen. Die einzelnen Laserstrahlen des Strahlungsfelds werden so geführt, daß sie jeweils zunächst auf die eine Reflexionsfläche eines Flächenpaars auftreffen, von dort auf die andere, gegenüberliegende Reflexionsfläche gerichtet werden, wodurch eine Drehung des Strahlungsquerschnitts erfolgt. Anschließend werden die im Strahlungsquerschnitt gedrehten Strahlungsanteile auf ein refraktives Element mit einer ebenen Eintrittsfläche und einer sphärisch gekrümmten Austrittsfläche gerichtet. Dieses refraktive Element führt die Strahlungsanteile senkrecht zu dem Verlauf der V-förmigen Nuten des reflektiven Elements zusammen. Ein weiteres refraktives Element, das dem ersten refraktiven Element nachgeordnet ist, fokussiert die divergierenden, einzelnen Strahlungsanteile.

Schließlich werden mit einem weiteren optischen, transmissiven Element die einzelnen Strahlungsanteile in eine Lichtleitfaser eingekoppelt. Mit dieser Anordnung sollen demzufolge Strahlungsanteile von einer Vielzahl von Lasern, wobei es sich um Diodenlaser handelt, in eine Lichtleitfaser eingestrahlt werden, wobei durch die die V-förmigen Nuten aufweisenden reflektiven Elemente die jeweiligen elliptischen Strahlungsquerschnitte, die für Diodenlaser typisch sind, gedreht werden.

In der US-A-4,986,634 ist eine Anordnung beschrieben, bei der mehrere Halbleiterlaser in einer Reihe angeordnet sind. Die einzelnen Laserstrahlen fallen auf jeweilige diesen Strahlen zugeordnete Spiegel, die zueinander versetzt sind. Die einzelnen Spiegelflächen der Spiegel sind so orientiert, daß aus dem Ausgangsstrahlungsfeld nach der ersten Reflexion an den Spiegeln ein Muster erhalten wird, bei dem die einzelnen Strahlungsquerschnitte näher zueinanderrücken, so daß der Füllfaktor erhöht wird. Die weitere Umlenkung der Strahlen, die von diesen Spiegeln reflektiert sind, erfolgt durch einen Strahlteiler, der dazu dient, die Strahlen mit den Strahlen eines weiteren linearen Laserfelds zu vereinigen.

Festkörper- und Halbleiterlaser haben in den vergangenen Jahren verstärkt Anwendung in der Materialbearbeitung und der Medizintechnik gefunden.

Ein weiteres Anwendungsgebiet der Festkörperlaser ist die Materialbearbeitung. Der Einsatzbereich von Festkörperlasern wird hierbei durch die erforderliche Wellenlänge der erzeugten Strahlung, die Leistung und die Form der Laser für das bestimmte Einsatzgebiet festgelegt. Da mit Festkörperlasern, insbesondere in niedrigen Leistungsklassen, hohe Strahlungsqualitäten erzeugt werden können, die in Verbindung mit kurzen Wellenlängen und entsprechenden Bearbeitungsoptiken sehr geringe Fokusdurchmesser ermöglichen, eröffnen sich den Festkörperlasern insbesondere Anwendungen bei schwierig zu bearbeitenden, hoch reflektierenden Materialien und bei Anwendungen, bei denen eine hohe Bearbeitungspräzision gefordert wird. Weiterhin sind als Vorteil die großen Frequenzbandbreiten der Festkörperlaser zu nennen, bei denen viele Moden, im Gegensatz beispielsweise zu Gaslasern, gleichzeitig schwingen. Als weiteres Merkmal eines Festkörperlasers ist dessen geringe Baugröße zu nennen, die bei einer typischen Länge von etwa 8 cm und einem typischen Durchmesser von 1 cm liegt. Anwendungsgebiete von Festkörperlasern im Bereich der Materialbearbeitung sind die Materialabtragung, das Bohren, das Trennen, das Fügen und das Schweißen.

Eine schnelle Weiterentwicklung haben in den letzten Jahren insbesondere Diodenlaser erfahren. Als typische Anwendungsgebiete sind die Materialbearbeitung sowie das Pumpen von Festkörperlasern aufzuführen.

Hochleistungslaserdioden besitzen typischerweise aktive Medien mit einem Querschnitt von 1 µm x 100 µm. Bedingt durch die Geometrie des aktiven Mediums ist die Strahlung, die von den Diodenlasern abgegeben wird, durch einen elliptischen Strahlquerschnitt und die große Divergenz in der schmalen Richtung und die relativ geringe Divergenz in der breiten Richtung bzw. der Verbindungsebene, als sogenannte Junction-Ebene bezeichnet, gekennzeichnet. Um mittels Diodenlasern höhere Leistungsdichten zu erzielen, ist es üblich, mehrere Laserdioden zu Laserdiodenfeldern- oder -arrays zusammenzufassen und deren Strahlung zu fokussieren. Zur Erzeugung von Strahlungsfeldern werden Laserdioden, sofern sie in einer Reihe angeordnet sind, mit der großen Achse ihres elliptischen Strahlquerschnitts parallel zueinander verlaufend angeordnet. Da die Strahlqualität in der schmalen Richtung beugungsbegrenzt ist und in der Junction-Ebene ca. 1.000-fach beugungsbegrenzt ist, kann die von einem Laserdiodenarray emittierte Strahlung nicht mit zylindrischen Linsen und sphärischen Linsen oder einer Kombination hieraus in einen kleinen und kreisförmigen Fleck fokussiert werden, was die Anwendung z.B. zur Einkopplung der Strahlung in eine optische Faser oder das sogenannte "End-on-Pumpen" von Festkörperlasern in Verbindung mit einem Laserdiodenarry einschränkt.

Auch bei den angesprochenen Festkörperlasern, insbesondere bei solchen einer niedrigen Leistungsklasse unter Ausnutzung der hohen Strahlqualitäten, ist es ebenfalls erforderlich, zur Erzeugung ausgedehnter Strahlungsfelder mit einer hohen Leistungsdichte mehrere solcher Festkörperlaser zu Arrays bzw. Feldanordnungen zusammenzufügen.

Ein Problem, das sich bei großen Feldanordnungen aus Festkörperlasern und Diodenlasern stellt, ist die Abführung der beim Lasern entstehenden Wärme, was wiederum entsprechende Kühlmaßnahmen erfordert, so daß zwischen den einzelnen Festkörpern bzw. aktiven Medien Abstände verbleiben müssen, um Kühlkörper vorzusehen oder Kühlkanäle zur Durchführung von Kühlfluiden zu bilden. Solche Kühlmaßnahmen begrenzen natürlich stark die Packungsdichte, mit der die Laser zu Laserarrays bzw. -feldanordnungen zusammengefaßt werden können.

Da für solche Strahlungsfelder, die von aus Diodenlasern oder Festkörperlasern zusammengestellten Arrays bzw. Feldanordnungen erzeugt werden, in der Abbildungsebene, d.h. beispielsweise auf der Werkstückoberfläche, bestimmte Strahlgeometrien und Leistungsdichten gefordert werden, muß die Strahlung, die von jedem einzelnen Festkörperlaser bzw. Diodenlaser abgegeben wird, entsprechend geführt und geformt werden.

Aufgrund der extrem unterschiedlichen Strahlqualitäten solcher Diodenarrays in den beiden unterschiedlichen Richtungen, d.h. aufgrund der in der schmalen Richtung beugungsbegrenzten Strahlqualität und der in der Junction-Ebene ca. 1000-fach beugungsbegrenzten Strahlqualität, kann die von einem Laserdiodenarray emittierte Strahlung nicht mit zylindrischen Linsen und sphärischen Linsen oder einer Kombination solcher optischen Bauteile in einen kleinen, kreisförmigen Fleck fokussiert werden. Dadurch sind derzeit die Anwendungen von Hochleistungsdiodenlasern auf Bereiche beschränkt, wo nur geringe Anforderungen an die Strahlqualität gestellt werden. Die Erweiterung der derzeitigen Anwendungen auf Gebiete wie die Medizintechnik und die Materialbearbeitung, die Faserkopplung und das End-on-Pumpen von Festkörper- und Faserlasern erfordert Transformationen der Hochleistungsdiodenlaserstrahlung.

Gleiches gilt für die angeführten Festkörperlaser mit hoher Strahlqualität dann, wenn aus solchen einzelnen Festkörperlasern die entsprechenden großen Strahlungsfelder, die benötigt werden, erzeugt werden sollen.

Eine weitere Anordnung zur Formung und Führung eines Strahlungsfelds, das von Laserdioden abgegeben ist, ist aus OPTICS LETTERS, Band 20, Nr. 2, 15.01.1995, Seiten 222-224 bekannt. Diese bekannte Anodnung weist ein reflektives Element auf, mit dem die kollimierten Strahlen der Diodenlaser um 90° durch Spiegelreflexionen gedreht werden. Insbesondere befaßt sich diese Druckschrift damit, die Spiegelkantenwinkel und -dicken eines sogenannten "three-mirror stack" zu berechnen.

Ausgehend von dem vorstehend angeführten Stand der Technik und der beschriebenen Problematik liegt der vorliegenden Erfindung die Aufgabe zugrunde, eine Anordnung und ein Verfahren anzugeben, mit denen die von Dioden- bzw. Festkörperlasern, d.h. aus diesen Lasern zusammengesetzte Diodenlaser- oder Festkörperlaser-Arrays, abgegebene Strahlung, oder aber die Strahlung, die von einem Laser, beispielsweise einem Diodenbarren, abgegeben wird (entsprechend in Strahlungsanteile unterteilt), mit einfachen und kostengünstigen Maßnahmen zu Strahlungsfeldern einer gewünschten Anordnung und Verteilung der Leistungsdichte transformiert werden können.

Die vorstehende Aufgabe wird gelöst durch eine Anordnung zur Formung und Führung eines Strahlungsfelds eines oder mehrerer Festkörper- und/oder Halbleiterlaser(s), insbesondere eines Strahlungsfelds eines Arrays bzw. einer Feldanordnung aus mehreren Lasern, mit einer Strahlungstransformationsoptik zur Erzeugung eines definierten Strahlungsfelds, wobei die Optik reflektive und refraktive Elemente (6, 9) aufweist, wobei die Reflexionsflächen der reflektiven Elemente (6) einen Versatz und/oder eine Verkippung derart zueinander aufweisen, daß mindestens zwei Strahlungsgruppen (8) des gemäß einer Vorgabe gruppierten Strahlungsfelds jeweils einem reflektiven Element (6) zugeordnet werden können und daß bei der Reflexion der Strahlungsgruppen (8) an den jeweiligen Reflexionsflächen die relativen Koordinaten der Strahlungsgruppen zueinander in einer ersten Richtung in einer Ebene senkrecht zur Ausbreitungseinrichtung des Strahlungsfelds nach der Reflexion gegenüber den entsprechenden relativen Koordinaten der Strahlungsgruppen (8) vor der Reflexion geändert werden, daß die refraktiven Elemente (9) derart angeordnet sind, daß die reflektierten Strahlungsgruppen (8), gegebenenfalls neu gruppiert, jeweils einem refraktiven Element (9) zugeordnet werden können, und daß bei der Brechung der Strahlungsgruppen (8) an den jeweiligen refraktiven Elementen die relativen Koordinaten der Strahlungsgruppen (8) zueinander in einer Ebene senkrecht zur Ausbreitungsrichtung des Strahlungsfelds nach der Brechung in einer zweiten Richtung mit einer Richtungkomponenten senkrecht zur ersten Richtung gegenüber den entsprechenden relativen Koordinaten der Strahlungsgruppen (8) vor der Brechung geändert wird.

Mit einer solchen Anordnung in ihrer einfachsten Ausführung können mit einer minimalen Anzahl von reflektiven Elementen und refraktiven Elementen mit einem hohen Leistungsübertragungskoeffizienten die Strahlungsanteile in Form eines gewünschten Strahlungsfelds in einer Abbildungsebene abgebildet werden. Mit der angegebenen Anordnung bzw. dem Verfahren ist es möglich, zunächst mittels einfacher, reflektiver Elemente unter Ausnutzung unterschiedlicher Einfallswinkel der einzelnen Strahlungsgruppen auf das jeweilige reflektive Element austrittsseitig einen definierten Versatz zu erzeugen, so daß die jeweiligen Strahlungsgruppen mit relativ zueinander geänderten Koordinaten und/oder Ausbreitungsrichtungen und/oder Orientierungen austreten. Die an den reflektiven Elementen reflektierten Strahlungsanteile werden dann neu gruppiert und treten in ein jeweils einer Gruppe zugeordnetes refraktives Element ein. Diese Gruppierung kann gegenüber der ersten Gruppierung, mit der die einzelnen Strahlungsanteile in die reflektiven Elemente eintreten, geändert werden, oder aber es kann die ursprüngliche Gruppierung beibehalten werden, d.h. jedem reflektiven Element ist jeweils ein refraktives Element zugeordnet, in das diejenigen Strahlungsanteile eintreten, die auch durch das jeweilige reflektive Element transformiert wurden. In den jeweiligen refraktiven Elementen wird die jeweilige Strahlungsgruppe dann so gebrochen, daß die Strahlungsgruppe mit gegenüber ihren Eintrittskoordinaten relativ zueinander geänderten Koordinaten und/oder Ausbreitungsrichtungen aus den refraktiven Elementen austreten. Dies bedeutet, daß sich austrittsseitig der refraktiven Elemente die austretenden Strahlungsgruppen in ihren relativen Koordinaten zueinander mit einer gegenüber der ersten Umorientierung geänderten Richtungskomponenten ausbreiten. Anders ausgedrückt wird die Strahlung, die von einer aus einzelnen Lasern zusammengesetzten Feldanordnung abgegeben wird, mit einer Ausdehnung senkrecht zur Strahlausbreitungsrichtung, d.h. in der x-y-Richtung, zunächst so auf die reflektiven Elemente eingestrahlt, daß die einzelnen Strahlungsgruppen unterschiedlich reflektiert werden und zunächst ein Versatz nach dem ersten reflektiven Element in der einen Ausbreitungsrichtung, d.h. beispielsweise in der y-Richtung, erzielt wird, die vorzugsweise senkrecht zu der größten Ausdehnung des Strahlungsfelds liegt. Austrittsseitig des reflektiven Elements sind dann die einzelnen Strahlungsgruppen in dieser x-Richtung nebeneinanderliegend und in der y-Richtung treppenstufenartig untereinander versetzt. Beispielsweise unter Beibehaltung dieser Gruppierung treten dann die versetzten Strahlungsgruppen jeweils in ein refraktives Element unter einem definierten Winkel und/oder einer Richtung ein, die eine zu der Einfallsrichtung auf das erste Element geänderte Richtungskomponente besitzt, so daß die einzelnen Strahlungsgruppen in den jeweiligen refraktiven Elementen derart gebrochen werden, daß sie austrittsseitig einen gegenüber der Eintrittsseite unterschiedlichen Versatz und/oder eine unterschiedliche Ausbreitungsrichtung, nunmehr in der x-Richtung, besitzen. Dies bedeutet wiederum, daß in einer Abbildungsebene dann die austrittsseitig des refraktiven Elements treppenstufenartig versetzten Strahlungsanteile untereinanderliegend zusammengeschoben sind und beispielsweise ein geschlossenes Strahlungsfeld bilden. Es wird anhand dieses Beispiels ersichtlich, daß aus einer beliebigen Anzahl einzelner Festkörper- und/oder Halbleiterlaser, gegebenenfalls gruppiert, unter Einsatz einer der Anzahl der Strahlungsgruppen entsprechenden Anzahl erster (reflektiver) und zweiter (refraktiver) Elemente, eine Umorientierung und/oder Umgruppierung der Strahlungsanteile in den zwei Raumrichtungen senkrecht zu der ursprünglichen Ausbreitungsrichtung des Strahlungsfelds erzielt werden kann. Hierbei wird ein hoher Wirkungsgrad der Leistungseffektivität, ein kompakter Aufbau unter Verwendung einer minimalen Anzahl von optischen Komponenten und ein hoher Freiheitsgrad bei der Ordnung und Umorientierung der Strahlungsanteile erreicht.

Obwohl die einzelnen Diodenlaser und/oder Festkörperlaser und somit deren Strahlungsquerschnitte einen bestimmten Abstand zueinander haben, kann mit diesen Maßnahmen nicht nur eine Umorientierung der Lage der einzelnen Strahlungsfelder austrittsseitig des zweiten Elements, d.h. der refraktiven Elemente, erzielt werden, sondern es ist in einfacher Weise möglich, die einzelnen Strahlungsfelder dichter zusammen zu legen und damit die Leistungsdichte pro Flächeneinheit zu erhöhen. Es wird ersichtlich, daß für eine solche Umorientierung und Veränderung der Leistungsdichteverteilung nur eine minimale Anzahl optischer Bauteile erforderlich ist, woraus sich wiederum ein kompakter Aufbau ergibt. Weiterhin kann mit der relativen Lage der Reflexionsflächen der reflektiven Elemente zu den einzelnen Festkörper- und/oder Halbleiterlasern sowie der Ausdehnung der reflektiven Elemente quer zur Ausbreitungsrichtung der Strahlung eine der erwünschten Abbildung und Leistungsdichteverteilung entsprechende Gruppierung vorgenommen werden. Dies bedeutet, daß zum Beispiel in das eine und/oder das andere reflektive Element die Strahlung eines oder mehrerer Laser (Einzelstrahlungsquelle) der Feldanordnung eingestrahlt wird, d.h. es wird bereits eingangsseitig der reflektiven Elemente eine Gruppierung der Strahlungsanteile des Strahlungsfelds vorgenommen. Die Anordnung eignet sich für beliebig gruppierte und aufgebaute Feldanordnungen aus Festkörper- und/oder Halbleiterlasern, d.h. für linienförmige Feldanordnungen bzw. Arrays oder aber beispielsweise für eine Feldanordnung mit mehreren, übereinandergestapelten, linienförmigen Laserarrays aus mehreren einzelnen Lasern (Einzelstrahlungsquelle), die ein senkrecht zur Ausbreitungsrichtung zweidimensionales Strahlungsfeld erzeugen.

Falls es erforderlich ist, werden zusätzliche Abbildungsoptiken eingesetzt, um, auch im Rahmen einer Gruppierung, die von den Einzelstrahlquellen abgegebene Strahlung auf die Elemente abzubilden.

In einer weiteren Ausbildung der Anordnung besitzen die einzelnen Reflexionsflächen der reflektiven Elemente jeweils einen unterschiedlichen Abstand zu den ihnen zugeordneten Strahl-Austrittsflächen der Laser bzw. der jeweiligen Lasergruppe des Arrays, deren Strahlung darauf einfällt, wobei der sich ändernde Abstand sequentiell der Reihenfolge der Gruppierung des Arrays entspricht; hierdurch ist es möglich, daß die Strahlungsanteile ausgangsseitig der Elemente eine annähernd parallele Ausbreitungsrichtung besitzt.

Entsprechend der Wahl des Abstands der einzelnen Strahlaustrittsflächen der Einzelstrahlungsquellen des Arrays oder deren Gruppierung zueinander wird vorzugsweise auch der Abstand der Reflexionsflächen sowie der Versatz der Reflexionsflächen zueinander ausgewählt und den Erfordernissen angepaßt.

Vorzugsweise liegen jedoch die Zentren der bestrahlten Reflexionsflächenbereiche der einzelnen Reflexionsflächen, auf die die jeweiligen Strahlen der einzelnen Einzelstrahlungsquellen auftreffen, auf einer Geraden, bevorzugt mit gleichen Abständen zueinander, d.h. diese Reflexionsflächen besitzen dann einen gleichen Versatz zueinander sowie einen sich um jeweils denselben Betrag ändernden Abstand zu den Austrittsflächen der Einzelstrahlungsquellen.

Als einfaches, reflektives Element, durch das die einzelnen Reflexionsflächen gebildet und geformt werden können, hat sich ein treppenstufenartig aufgebauter Spiegel als vorteilhaft erwiesen. Ein solcher treppenstufenartig aufgebauter Spiegel kann in Form eines entsprechend mit einer Spiegelfläche beschichteten Substratträgers, beispielsweise durch Aufdampfen, bereitgestellt werden. Es ist allerdings auch möglich, einen solchen Treppenstufenspiegel auf einem Glassubstrat mittels Diamantwerkzeugen einzuschleifen, wobei ein solcher Treppenstufenspiegel den Vorteil hat, daß er äußerst stabil und verzugsfrei ist. Auch können die reflektiven Elemente, wie sie vorstehend aufgezeigt sind, auf einfach herstellbare Trägerkörper aus Kunststoff aufgebracht werden. Gerade in Bezug auf solche Kunststoffträger, die beispielsweise mittels Spritzgießtechniken hergestellt werden können, ergibt sich eine sehr kostengünstige Anordnung.

Die erfindungsgemäße Anordnung hat weiterhin den Vorteil, daß die Reflexionsflächen durch ebene Spiegelelemente gebildet werden können, die also sehr einfach herstellbar sind. Die einzelnen Reflexionsflächen können aber auch konkav oder konvex gekrümmte Flächen sein, um die Strahlquerschnitte der Strahlungsanteile, aus denen das Strahlungsfeld zusammengesetzt ist, zusätzlich aufzuweiten oder zu fokussieren. Krümmungen in Form von Zylindermantelsegmentflächen sind zu bevorzugen, um beispielsweise eine Fokussierung nur in einer Richtung, die beeinflußt werden soll, zu erreichen.

Um einen Versatz ausgangsseitig des jeweiligen refraktiven Elements zu erreichen, ist eine einfache Maßnahme diejenige, den einzelnen Strahlungsgruppen unterschiedlich lange Ausbreitungswege in den refraktiven Elementen zuzuordnen. Dies kann zum einen durch unterschiedliche Einfallswinkel der jeweiligen Strahlengruppe in das ihr zugeordnete refraktive Element erfolgen, oder aber die jeweiligen refraktiven Elemente können eine unterschiedliche Länge besitzen, so daß dadurch der Weg durch das jeweilige Element verlängert und damit der Versatz austrittsseitig vergrößert wird.

Um beispielsweise ein Strahlungsfeld, das aus zueinander gleichen Strahlungsgruppen aufgebaut ist, zu erzeugen, wie beispielsweise ein solches, bei dem jeweils eine Strahlungsgruppe der Strahlung entspricht, die von einer oder zwei Einzellaserquellen abgegeben wird, um eine gleichmäßige, abgestufte Umorientierung zu erreichen, die jeweiligen refraktiven Elemente so dimensioniert und relativ mit ihren Eintrittsflächen zu der Ausbreitungsrichtung der jeweiligen Strahlungsgruppe ausgerichtet, daß unmittelbar benachbarte Strahlungsgruppen gleiche Differenzen ihrer Ausbreitungsweglängen aufweisen. Dadurch wird ein von Strahlungsgruppe zu Strahlungsgruppe gleicher Versatz austrittsseitig der refraktiven Elemente erzielt. In einer einfachen Ausführung sind, um einen solchen gleichmäßigen Versatz von refraktivem Element zu refraktivem Element zu erhalten, die Austrittsflächen der refraktiven Elemente treppenstufenartig zueinander versetzt, was wiederum bedeutet, die einzelnen refraktiven Elemente besitzen eine unterschiedliche Länge in Strahlausbreitungsrichtung. Weiterhin kann es zur Erzeugung eines gleichförmigen Versatzes der jeweiligen Strahlungsgruppen zueinander vorteilhaft sein, die Austritts- und/oder Eintrittsflächen der refraktiven Elemente so anzuordnen, daß sie in einer zueinander parallel verlaufenden Ebene liegen. Vorzugsweise sind aber die den Strahlungsgruppen jeweils zugeordneten Eintrittsflächen der refraktiven Elemente in einer Ebene liegend ausgerichtet und der treppenstufenartige Versatz an der Austrittsseite der refraktiven Elemente gebildet, da der Divergenzwinkel durch die Brechung innerhalb der refraktiven Elemente dann kleiner ist und dadurch die Gruppierung definierter erreicht werden kann, im Gegensatz zu dem Fall, bei dem der Versatz an der Eintrittsseite liegt.

Eine weitere, einfache Maßnahme, um den erwünschten Versatz aufgrund der unterschiedlichen Brechung der einzelnen Strahlungsgruppen in den refraktiven Elementen zu erzielen, ist diejenige, wenigstens einen Teil der refraktiven Elemente mit unterschiedlichen Brechungsindizes auszustatten, beispielsweise durch eine unterschiedliche Art eines für das refraktive Element einzusetzenden Glaskörpers oder durch eine unterschiedliche Dotierung eines Glaskörpers, vorzugsweise aus Quarzglas, das sich durch seine hohe Reinheit auszeichnet, als brechwerterhöhende oder brechwerterniedrigende Maßnahme. Hierbei kann wiederum eine gleichförmige Abstufung zur Erzeugung eines gleichförmigen Versatzes benachbarter Strahlungsgruppen von Vorteil sein, indem jeweils benachbarte refraktive Elemente unterschiedliche Brechungsindizes aufweisen, die vorzugsweise unter gleichen Verhältnissen zu- oder abnehmen.

Um zu verhindern, daß Strahlungsanteile eines refraktiven Elements in jeweils benachbarte refraktive Elemente eintreten, werden benachbarte refraktive Elemente voneinander durch eine Schicht getrennt, die ein gegenüber dem angrenzenden refraktiven Element geringeren Brechungsindex aufweist. Strahlungsanteile in einem refraktiven Element, die aufgrund des Divergenzwinkels der Strahlung in die Randzone des refraktiven Elements gelangen, werden dann zur Mitte des refraktiven Elements hin durch Totalreflexion reflektiert.

Wie bereits vorstehend ausgeführt ist, wird mit dem Einsatz der refraktiven Elemente zur Veränderung der Koordinaten der eintretenden Strahlungsgruppen zueinander und/oder zur Änderung der Ausbreitungsrichtungen eine sehr einfache Möglichkeit gegeben, die angestrebten Strahlungsfelder und Leistungsdichten zu erzielen. Um der Strahlung, die aus einem refraktiven Element austritt, zusätzlich zu der Richtung, in der die Strahlung in den refraktiven Elementen gebrochen wird, eine zusätzliche Richtungskomponente zu verleihen, sind solche refraktiven Elemente von Vorteil, bei denen die Eintritts- und/oder die Austrittsflächen zum einen senkrecht auf einer gemeinsamen Ebene stehen, zum anderen aber um Achsen, die in der Ebene dieser Flächen und parallel zueinander verlaufen, zueinander verschwenkt sind. Durch diese unterschiedliche Ausrichtung der Eintritts- und/oder der Austrittsflächen, vorzugsweise in einer Richtung senkrecht zu der Richtung, in der die Strahlung gebrochen wird, wird die Ausbreitungsrichtung der einzelnen Strahlungsgruppen zueinander geändert und damit werden deren Koordinaten zueinander geändert. Darüberhinaus besteht die Möglichkeit, diese Flächen geringfügig konkav oder konvex zu wölben, um die jeweilige Strahlung der Strahlungsgruppen aufzuweiten oder zu fokussieren. Eine weitere, einfache Möglichkeit, ein Strahlungsfeld in einer Richtungskomponenten aufzuweiten, ist dann gegeben, wenn die Eintritts- und/oder Austrittsflächen der refraktiven Elemente jeweils senkrecht auf einer gemeinsamen Ebene stehen und um Achsen, die in der Ebene dieser Flächen und parallel zueinander verlaufen, zueinander verschwenkt sind. Solche Maßnahmen können sowohl bei den jeweils ersten refraktiven Elementen als auch bei den jeweils zweiten refraktiven Elementen vorgenommen werden, wobei allerdings diese Maßnahme vorzugsweise an den zweiten refraktiven Elementen angewandt wird, und zwar dort wiederum bevorzugt an den Strahlungs-Austrittsflächen.

Wie bereits vorstehend erläutert wurde, stellt ein grundsätzlicher Nachteil einer Feldanordnung bzw. eines Arrays aus einzelnen Festkörperlasern und/oder Diodenlasern deren geringer Füllfaktor dar. Als Füllfaktor ist beispielsweise in einer Austrittsebene, in der die Austrittsfenster der einzelnen Laser liegen, die Summe der Querschnittsflächen der einzelnen Laserstrahlen bezogen auf die Gesamtfläche, die durch die Austrittsfenster der Feldanordnung aufgespannt wird, zu verstehen. In vielen Anwendungen ist es erwünscht, zum einen einen sehr gleichförmigen Füllfaktor zu erzielen, d.h. die mit der Laserstrahlung bestrahlte Fläche soll mit einer gleichförmigen Intensität in allen Flächenbereichen bestrahlt werden, wobei dann eine Maßnahme dahingehend anzuwenden ist, daß dann, wenn die Querschnittsabmessungen der Strahlungsanteile einzelner Strahlungsgruppen kleiner als die Breite des zugeordneten refraktiven oder reflektiven Elements ist, die jeweilige Strahlungsgruppe in die Eintrittsfläche des jeweiligen refraktiven Elements bzw. des reflektiven Elements unter einem Einfallswinkel ungleich 0° derart eintritt, daß annähernd die gesamte Breite der Eintrittsfläche des refraktiven Elements oder die Reflexionsfläche des reflektiven Elements ausgeleuchtet ist. Diese Maßnahme wird vorzugsweise bei refraktiven Elementen dann angewandt, wenn das gesamte refraktive Element aus einem einzelnen, zusammenhängenden Körper gebildet ist.

Um entweder gleichförmige Strahlungsfelder mit einer relativ großen Ausdehnung zu erzeugen oder um einen kleinen Strahlungsfleck hoher Strahlungsdichte in der Arbeitsebene zu erhalten, werden mehrere streifenförmige Strahlungsfelder, die aus einzelnen Lasern aufgebaut sind, parallel zueinander ausgerichtet, so daß die Ausgangsstrahlung durch eine Laserfeldanordnung abgegeben wird, die aus einer vorgegebenen Anzahl linienförmiger Laserarrays zusammengesetzt ist, wobei jedes linienförmige Laserarray aus einer Anzahl Einzellaser aufgebaut ist.

Im Rahmen der erfindungsgemäßen Strahlungstransformation wird jeweils angestrebt, daß nach dem letzten transformierenden Element - falls es erforderlich ist, können Transformationen mittels mehr als zwei Elementen vorgenommen werden die aus dem letzten Element austretenden bzw. reflektierten Strahlungsgruppen zueinander parallele Ausbreitungsrichtungen oder einen gemeinsamen Schnittpunkt haben.

Sowohl die reflektiven Elemente als auch die refraktiven Elemente besitzen ihre spezifischen Vorteile. Reflektive Elemente zeichnen sich dadurch aus, daß nur ein Flächenelement erforderlich ist, um die angestrebte Transformation zu erzielen. Sie sind kostengünstig herstellbar. Sie können darüberhinaus hohen Belastungen standhalten. Refraktive Elemente zeichnen sich dadurch aus, daß nur ein Körper erforderlich ist, um einen erforderlichen Versatz zwischen der Eintritts- und Austrittsfläche zu erzielen. Darüberhinaus kann bei refraktiven Elementen die Orientierung der Austrittsfläche so gewählt werden, daß an diesen Austrittsflächen ein weiterer Versatz der austretenden Strahlungsanteile erzielt wird. Weiterhin sind mit refraktiven Elementen hohe Belegungsdichten mit einer definierten Zuordnung der einzelnen refraktiven Elementen den jeweiligen Strahlungsanteilen möglich. Darüberhinaus können solche refraktiven Elemente so aufgebaut und angeordnet werden, daß die Strahlungsanteile jeweils mit gleichen Divergenzwinkeln in die Eintrittsflächen eintreten, so daß in etwa gleiche Verhältnisse erzielt werden. Schließlich ist ein Vorteil darin zu sehen, daß die Strahlung in den refraktiven Elementen geführt wird und sie somit in diesem Bereich keinen äußeren Störeinflüssen unterliegt.

Um die Vorteile, die mit den Maßnahmen nach den einzelnen Ansprüchen, die vorstehend erläutert sind, besser zu verdeutlichen sowie weitere Merkmale der Erfindung aufzuzeigen, werden nun verschiedene Ausführungsbeispiele der Erfindung anhand der Zeichnungen beschrieben.

In den Zeichnungen zeigen:
- Figuren 1A bis 1E: schematisch verschiedene ein- und zweidimensionale Laserarrays, in Verbindung mit denen die erfindungsgemäßen Anordnungen einsetzbar sind,
- Figuren 2A und 2B: eine erste Ausführungsform der erfindungsgemäßen Anordnung zur Formung und Führung eines Strahlungsfelds eines eindimensionalen, geradlinigen Laserarrays, das in den Figuren 1A oder 1B dargestellt ist, unter Verwendung eines reflektiven Elements (Figur 2A) und eines nachgeordneten refraktiven Elements (Figur 2B),
- Figur 3: eine gegenüber dem refraktiven Element der Figur 2B geänderte Ausführungsform eines refraktiven Elements,
- Figur 4: eine Ausführungsform ähnlich der Ausführungsform der Figuren 2B mit zusätzlichen reflektiven Flächen austrittsseitig der refraktiven Elemente,
- Figuren 5A und 5B: eine Anordnung mit reflektiven Elementen (Figur 5A) und nachgeordneten refraktiven Elementen (Figur 5B), wobei den drei jeweiligen Elementen eine Feldanordnung aus drei Reihen mit jeweils drei Einzellasern zugeordnet ist,
- Figur 6: einen Stapel refraktiver Elemente in Form einzelner Glasplatten, wobei zu den einzelnen Platten in der unteren Graphik quer zur Erstreckung der Glasplatten der Brechungsindex aufgetragen ist,
- Figuren 7A und 7B: refraktive Elemente, die durch einzelne Glasplatten gebildet sind, wobei jede Glasplatte einen unterschiedlichen Brechungsindex aufweist,
- Figur 8A: eine Ansicht auf die Anordnung der Figuren 7A und 7B aus Richtung des Pfeils VIIIA in den Figuren 7A und 7B,
- Figur 8B: eine Draufsicht auf die Anordnungen der Figur 8A aus Richtung des Sichtpfeils VIIIB in Figur 8A,
- Figuren 9A und 9B: zu den Figuren 8A und 8B entsprechende Darstellungen, wobei im Gegensatz zu den Figuren 8 die einzelnen Strahlen der Strahlungsgruppen in unterschiedlichen Höhen in das jeweilige refraktive Element eintreten und unter einer gleichen Höhe aus dem jeweiligen refraktiven Element austreten,
- Figur 10: schematisch eine seitliche Darstellung einer Anordnung, mit der die einzelnen Strahlungsgruppen in einem Glasplattenstapel entsprechend der Figur 7A mehrfach gefaltet werden,
- Figur 11A: eine erfindungsgemäße Anordnung, die zur Erhöhung der Beleuchtungsdichte bzw. des Füllfaktors dient,
- Figur 11B: schematisch die Strahlungsquerschnittsverteilung des Strahlungsfelds eingangsseitig und ausgangsseitig der Anordnung der Figur 11A,
- Figur 12: eine perspektivische Anordnung einer Treppenstufenspiegelanordnung zur Erhöhung des Füllfaktors,
- Figur 13: die Anordnung der Figur 13, wobei jedem Treppenstufenspiegel ein lineares Laserarray zugeordnet ist,
- Figur 14: die Anordnung nach der Figur 13, wobei den einzelnen treppenförmigen Spiegelelementen jeweils eine lineare Laser-Feldanordnung zugeordnet ist,
- Figur 15 und Figur 16: jeweils einen Treppenstufenspiegel mit konkav gekrümmten Spiegelflächen,
- Figur 17: einen Treppenstufenspiegel, bei dem die einzelnen Spiegelflächen um eine gemeinsame Achse jeweils um einen gleichen Winkel zueinander verschwenkt sind,
- Figur 18: eine weitere Ausführungsform eines Treppenstufenspiegels, bei dem die einzelnen Spiegelflächen einen unterschiedlichen Versatz zueinander haben und unterschiedlich zueinander geneigt sind,
- Figuren 19A und 19B: ein reflektives Element (Figur 19A) und ein refraktives Element (Figur 19B), mit denen das Strahlungsfeld eines linearen Laserarrays in drei Strahlungsanteile gruppiert und zu einem annähernd runden Strahlungsfeld geformt wird, und
- Figur 20: schematisch einen weiteren Treppenstufenspiegel mit einer weiteren, beispielhaften Gruppierung der Strahlungsfelder.

Die erfindungsgemäße Anordnung in den verschiedenen möglichen Ausführungsformen ist zur Formung und Führung eines Strahlungsfelds eines Arrays bzw. einer Feldanordnung geeignet, die aus mehreren Festkörper- und/oder Halbleiterlasern zusammengesetzt ist. Sie ist aber auch zur Formung eines Strahlungsfelds, das von einem einzelnen Laser abgegeben wird, geeignet, beispielsweise für die Strahlung eines Diodenbarrens mit einem langgestreckten Strahlungsfeld, das umgeordnet bzw. transformiert werden soll.

Da einzelne Laserstrahlquellen in Form von Festkörper- und Diodenlasern nur begrenzt zu höheren Leistungen skalierbar rind, wird zum Erzielen höherer Laserleistungen und Leistungsdichten eine größere Anzahl einzelner Laserstrahlenquellen zu verschiedenen Arrays oder Feldanordnungen zusammengefaßt. Verschiedene dieser Feldanordnungen sind in den Figuren 1A bis 1E dargestellt.

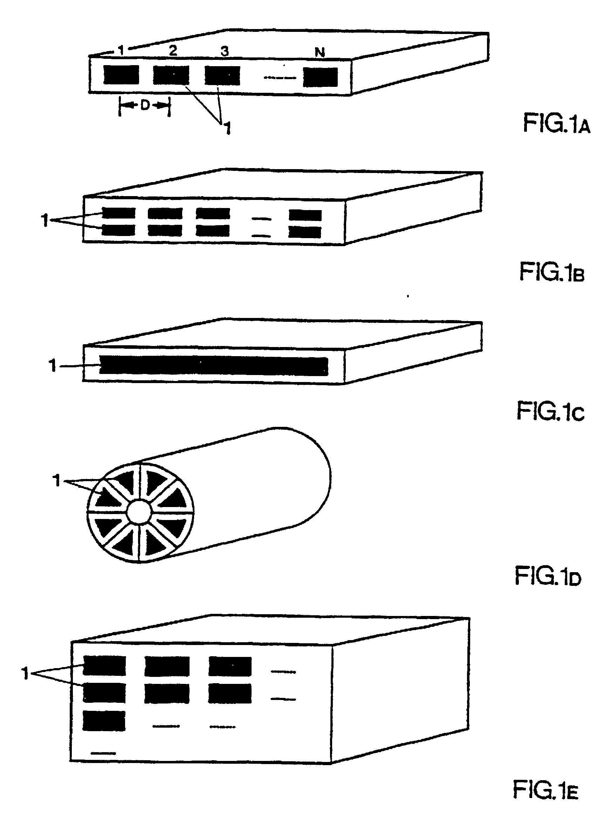

Hierbei kann man lineare Feldanordnungen, wie sie in den Figuren 1A und 1C dargestellt sind, doppelt-lineare Feldanordnungen, wie dies beispielsweise in Figur 1B dargestellt ist, radiale Feldanordnungen entsprechend der schematischen Darstellung der Figur 1D sowie zweidimensionale Arrays gemäß der schematischen Darstellung der Figur 1E unterscheiden.

Ein lineares Array, wie es die Figur 1A darstellt, weist N-Einzelstrahlungsquellen auf, so daß sich eine langgestreckte, lineare Strahlungsverteilung ergibt. Nachteilig ist die lineare Geometrie für solche Fälle, in denen kreisförmige oder quadratische Strahlungsflächen mit einem hohen Füllfaktor in einer Abbildungs- oder Bearbeitungsebene erzielt werden sollen.

Soweit im Rahmen dieser Beschreibung der Begriff "Füllfaktor" verwendet wird, so ist hierunter die Strahlquerschnittsfläche der einzelnen Strahlungsquellen, in den Figuren 1 mit dem Bezugszeichen 1 bezeichnet, zu der Gesamtfläche, die durch die Einzelstrahlungsquellen 1 aufgespannt wird, zu verstehen.

Ein Nachteil eines linearen Arrays gemäß Figur 1A aus Einzelstrahlungsquellen ist derjenige, daß in der Längsrichtung die Strahlqualität mindestens um einen Faktor N gegenüber der Einzelstrahlungsquelle verringert ist. Bei einer eindimensionalen, linearen Anordnung liegt daher eine gewisse Asymmetrie der Emission des Strahlungsfelds hinsichtlich der Querschnittsgeometrie und der Strahlqualität vor, die in einem Maße ansteigt, wie versucht wird, die Anzahl der Einzelstrahlungsquellen und damit die Gesamtleistung zu erhöhen. Zweidimensionale Arrays entsprechend der Figur 1B, oder insbesondere Arrays, die aus mehr als zwei linearen Einzelarrays zusammengesetzt sind, wie dies in der Figur 1E dargestellt ist, weisen den Nachteil der geringen Zugänglichkeit der inneren Einzelstrahlungsquellen auf, um diese beispielsweise zu kühlen (Diodenlaser) oder anzuregen (Festkörperlaser). Um die Kühlmaßnahmen und die erforderlichen Maßnahmen zur Anregung zu erfüllen, müssen die Abstände D (siehe Figur 1A) der Einzelstrahlungsquellen 1 zueinander vergrößert werden, wodurch natürlich der Füllfaktor am Ort der Strahlungsemission herabgesetzt wird.

Eine weitere Möglichkeit, den Füllfaktor zu erhöhen, ist mit einer Anordnung gegeben, die in der Figur 1D dargestellt ist. Die einzelnen Quellen 1 besitzen einen kreissegmentförmigen Emissionsquerschnitt, die um eine zentrale Achse herum angeordnet sind.

Wie anhand der Figuren 1A bis 1E veranschaulicht ist, ist es für hohe Strahlungsleistung und hohe Strahlungsdichten sowie große Füllfaktoren alleine nicht ausreichend, die Anzahl der Einzelstrahlungsquellen zu erhöhen, da auch eine mehrdimensionale Anordnung von Einzelstrahlungsquellen ihre Grenzen besitzt. Größere Feldanordnungen erfordern zum Beispiel, um die innenliegenden Strahlungsquellen entsprechend zu versorgen, größere Abstände D der Einzelstrahlungsquellen.

Um weitgehendst von der Anordnung der Einzelstrahlungsquellen unabhängig zu sein, ist es somit erforderlich, die Strahlung der einzelnen Strahlungsquellen 1 mittels nachgeordneter optischer Anordnungen in ihren Koordinaten relativ zueinander und/oder in der Ausbreitungsrichtung der einzelnen Strahlen zueinander und/oder der Orientierung des Einzelstrahls so zu verändern, daß bei vorgegebenem Aufbau einer Feldanordnung aus mehreren Festkörper- und/oder Halbleiterlasern definierte Strahlungsfelder in einer Abbildungsebene erzeugt werden können.

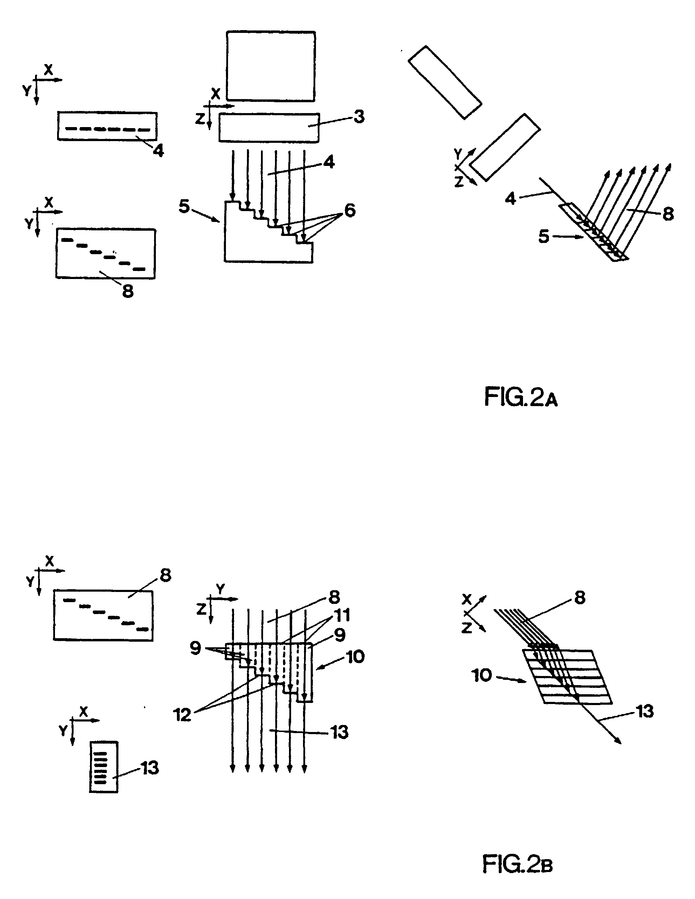

Gemäß einer ersten Ausführungsform der Erfindung, die in den Figuren 2A und 2B dargestellt ist, wird die von einer Festkörper- oder einer Halbleiterlaser-Feldanordnung 1, die eine lineare Anordnung aus sechs Einzelstrahlungsquellen 1 ist, wie dies auch vergrößert in der Figur 1A dargestellt ist, ausgehende Strahlung 4 auf ein erstes Element 5 gerichtet, das aus einzelnen reflektiven Elementen bzw. Reflexionsflächen 6, in Form eines Treppenstufenspiegels, aufgebaut ist. An den einzelnen Reflexionsflächen 6 des ersten Elements bzw. des Treppenstufenspiegels 5 werden die einzelnen Strahlen 4 reflektiert. Der Einstrahlwinkel auf die Reflexionsflächen 6 und die Stufenhöhe, d.h. der seitliche Versatz der einzelnen Reflexionsflächen 6 zueinander, sowie gegebenenfalls der Abstand der Reflexionsflächen 6 von der Strahlaustrittsebene 7 der Laser-Feldanordnung 3 sind so abgestimmt, daß die reflektierten Strahlungsgruppen 8, wie in Figur 2A links unten dargestellt ist, treppenstufenartig zueinander versetzt sind.

Die an den reflektiven Elementen 6 reflektierten Strahlungsgruppen 8 können dann neu gruppiert werden, obwohl dies in den Figuren nicht dargestellt ist, und entsprechend der Vorgaben wird jede Strahlungsgruppe 8 in ein ihr zugeordnetes refraktives Element 9 eines zweiten Elements 10 eingestrahlt. In der Ausführungsform, die in Figur 2A dargestellt ist, ist das zweite Element 10 aus sechs einzelnen refraktiven Elementen 9 zusammengesetzt, wie die unterbrochenen Linien andeuten. Wie in der rechten Darstellung der Figur 2A zu sehen ist, fallen die einzelnen Strahlungsanteile 8 unter einem Einfallswinkel ungleich 0° auf die stirnseitigen Strahlungs-Eintrittsflächen 11 der refraktiven Elemente 9 auf, so daß sie innerhalb der jeweiligen refraktiven Elemente 9 gebrochen werden. Da die einzelnen refraktiven Elemente 9 einen gleichen Brechungsindex haben bzw. aus einem gleichen, transparenten Werkstoff hergestellt sind, erfahren die einzelnen Strahlungsanteile 8 einen gleichen Brechungswinkel an den Strahlungs-Eintrittsflächen 11 der refraktiven Elemente 9. Durch die unterschiedliche Länge der einzelnen refraktiven Elemente 9 wird bewirkt, daß die einzelnen Strahlungsanteile 8 einen unterschiedlich langen Weg durch das jeweilige refraktive Element 9 zurücklegen, so daß sie unter unterschiedlichen Höhen, verglichen mit der relativen Lage auf den Strahlungs-Eintrittsfläche 11, aus der Strahlungs-Austrittsfläche 12 austreten, wie dies in Figur 2A links unten dargestellt ist. Aufgrund des gleichen, treppenstufenartigen Versatzes zueinander an der Strahlungs-Eintrittsfläche 11 tritt an der Strahlungs-Austrittsfläche 12 ein jeweils gleicher Versatz der Strahlungsquerschnitte untereinander auf. Aufgrund der Abstufung der refraktiven Elemente 9 des zweiten Elements 10 entgegengesetzt der Abstufung der reflektiven Elemente 6 des ersten Elements 5 von dem einen äußeren Strahlungsanteil zu dem anderen äußeren Strahlungsanteil werden die Gesamtausbreitungswege der jeweiligen Strahlungsanteile etwa gleich lang gestaltet und können in einer gemeinsamen Ebene abgebildet werden.

An den refraktiven Elementen 9 erfolgt die Brechung aufgrund des Einfallswinkels der einzelnen Austrittsstrahlen 8 auf die Strahlungs-Eintrittsflächen 11 in einer Richtung, die um 90° zu der Einfallsrichtung der einzelnen Strahlungsanteile 4 auf das erste Element 5 gedreht ist. Hierdurch werden die einzelnen Strahlungsanteile 8 derart gebrochen, daß die aus den Strahlungs-Austrittsflächen 12 des zweiten Elements 10 austretenden Austrittsstrahlen 13 versetzt austreten; dadurch werden die einzelnen Strahlungsquerschnitte übereinandergeschoben, wie dies in der linken, unteren Darstellung der Figur 2B zu sehen ist. Die Größe des Versatzes der Austrittsstrahlen 13 an der Strahlungs-Austrittsfläche 12 kann zum einen in Abhängigkeit der Brechungsindizes der jeweiligen refraktiven Elemente 9 und zum anderen über die Weglänge des jeweiligen Strahlungsanteils 8 durch das ihm zugeordnete refraktive Element 9 eingestellt werden. Wie die Figuren 2A und 2B zeigen, werden durch die beiden Elemente 5 und 10 bzw. deren reflektiven Elemente 6 und deren refraktiven Elemente 9 die Strahlungsanteile zweimal so transformiert, daß sie zum einen durch die reflektiven Elemente 6 in der einen Richtung senkrecht zur Ausbreitungsrichtung unterschiedlich versetzt werden, während sie durch die refraktiven Elemente 9 in der Richtung, die sowohl senkrecht zur Ausbreitungsrichtung der Strahlungsanteile 8 als auch senkrecht zu der ersten Richtung der Brechung liegt, wieder übereinandergeschoben werden , so daß die Strahlungsquerschnitte, ausgehend von einer linearen Anordnung, zu einem dichten Strahlungsfeld hoher Strahlungsintensität zusammengeführt werden können. Basierend auf dem Prinzip, wie es in den Figuren 2A und 2B dargestellt ist, können andere Strahlgeometrien, ausgehend von einer linearen Anordnung, gebildet werden.

Die Anordnung der Figuren 2A und 2B besitzt einen besonderen Vorteil bei der Strahlungsformung und -führung eines Strahlungsfelds, das aus Diodenlasern zusammengesetzt ist. Typischerweise werden in einer linearen Feldanordnung einzelner Diodenlaser 24 Dioden über eine Länge von 1 cm integriert. Eine solche Laserdioden-Feldanordnung mit einem Strahlquerschnitt von 1 µm x 10 mm besitzt extrem unterschiedliche Strahlqualitäten in den beiden unterschiedlichen Richtungen ihres elliptischen Strahlquerschnitts. So ist die Strahlqualität in der schmalen Richtung, d.h. in der Junction-Ebene, ca. 1000-fach beugungsbegrenzt. Gerade in Verbindung mit einer solchen Laserdiodenfeldanordnung, bei der dann gemäß der Figur 2A jedem Emitter ein reflektives Element und ein refraktives Element zugeordnet wird, werden in dem ersten Element 5 laterale Versätze zwischen den Emittern in der y-Richtung erzeugt. Der Einfallswinkel und die Versätze werden dann so abgestimmt, daß der Versatz zwischen den benachbarten Streifenemittern ein wenig größer als die Strahldimension in der y-Richtung wird. Das zweite Element 10 erzeugt dann Versätze unter ensprechender Wahl der Einfallsrichtung der Strahlung auf die Strahlungs-Eintrittsflächen 11 und durch geeignete Wahl der Ausbreitungslänge in den jeweiligen refraktiven Elementen 9 in der x-Richtung (Slow-Richtung) und durch geeignete Wahl der beeinflußbaren Faktoren werden die Strahlungsanteile in der y-Richtung untereinander angeordnet. Die Strahlqualität entlang der y-Achse ist dann um einen Faktor der Emitteranzahl (in dem gezeigten Beispiel 6) verringert und gleichzeitig erhöht sich die Strahlqualität in der Slow-Richtung (x-Richtung) um den gleichen Faktor. Dadurch werden die Strahlqualitäten in den beiden Richtungen vergleichbar sein und die Gesamtstrahlung der Diodenlaser-Feldanordnung kann in einen kreisförmigen oder rechteckigen Fleck fokussiert werden.

An dieser Stelle ist anzumerken, daß in den einzelnen Figuren der verschiedenen Ausführungsformen identische oder vergleichbare Bauteile mit denselben Bezugszeichen bezeichnet sind. Eine sich wiederholende Beschreibung dieser Teile wird nicht vorgenommen, so daß die Beschreibung dieser Teile anhand des einen Ausführungsbeispiels analog auf das jeweils andere Ausführungsbeispiel zu übertragen ist.

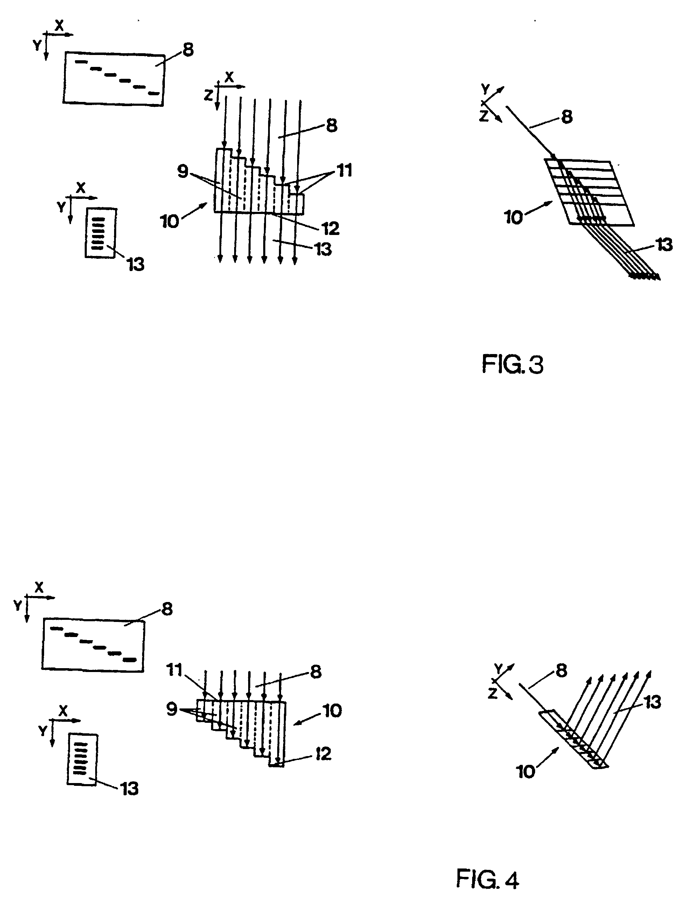

In der Figur 3 ist eine Anordnung dargestellt, die mit der Anordnung der Figur 2B vergleichbar ist. In dieser Ausführungsform der Figur 3 ist das Element 10 so orientiert, daß die Strahlungs-Austrittsflächen 12 jeweils in einer Ebene liegen, während die Strahlungs-Eintrittsflächen 11 treppenstufenartig ausgeführt sind. Aufgrund der unterschiedlichen Wege der jeweiligen Strahlungsanteile durch das jeweils zugeordnete refraktive Element 9 wird wiederum ein Versatz erzeugt, so daß entsprechend der Figuren 2B ein Strahlungsfeld 13 erzeugt wird, wie es links unten in der Figur dargestellt ist. Der Ausführungsform des zweiten Elements 10 der Figuren 2B ist gegenüber der Ausführungsform der Figur 3 der Vorzug zu geben, da durch die gemeinsame Ebene, in der die Strahlungs-Eintrittsflächen 11 liegen, eine exaktere Gruppierung realisiert werden kann.

Anhand der Figuren 2 und 3 wird ersichtlich, daß in Abhängigkeit davon, welche Strahlungsmuster aus den einzelnen Strahlungsquerschnitten erzeugt werden sollen, die Treppenstufen auch in anderer Weise abgestuft werden können, beispielsweise auch derart, daß etwa die refraktiven Elemente 9 des zweiten Elements 10 mit der größten Ausdehnung in der Strahlrichtung in der Mitte des Elements 10 angeordnet sind.

Die refraktiven Elemente 9 des zweiten Elements 10 werden vorzugsweise aus einem einzelnen Glaskörper gearbeitet; eine weitere alternative Ausführungsform, die noch nachfolgend beschrieben wird, besteht darin, die einzelnen refraktiven Elemente 10 aus Glasplatten zusammenzusetzen.

In der Figur 4 ist eine Ausführungsform refraktiver Elemente 9 entsprechend der Figur 2B dargestellt; im Gegensatz zu der Ausführungsform nach der Figur 2B sind in diesem Ausführungsbeispiel der Figur 4 die Strahlungs-Austrittsflächen 12 verspiegelt. Hierdurch wird erreicht, daß die in den einzelnen refraktiven Elementen 9 ausbreitenden Strahlungsanteile 8 auf diese verspiegelten Flächen auftreffen und, in Abhängigkeit des Winkels, mit dem sie auf diese Flächen auftreffen, reflektiert werden, so daß sie seitlich aus dem Element 10 austreten, wie dies in der rechten Darstellung der Figur 2B dargestellt ist. Während in der Figur 4 diese verspiegelten Endflächen 12 so dargestellt sind, daß sie parallel zu den Eintrittsflächen 11 verlaufen, kann der Ausbreitungsrichtung der an den Endflächen 12 reflektierten Strahlungsanteile 8 eine zusätzliche, geänderte Richtungskomponente durch eine geänderte Schrägstellung dieser Flächen verliehen werden. Auf diese Art und Weise kann die eintretende Strahlung 8 zum einen durch die unterschiedlich lange Ausbreitungsrichtung in den refraktiven Elementen 9 in einer Richtung transformiert werden, während sie durch die End-Spiegelflächen 12 mit einer zusätzlichen anderen Richtungskomponenten transformiert werden kann.

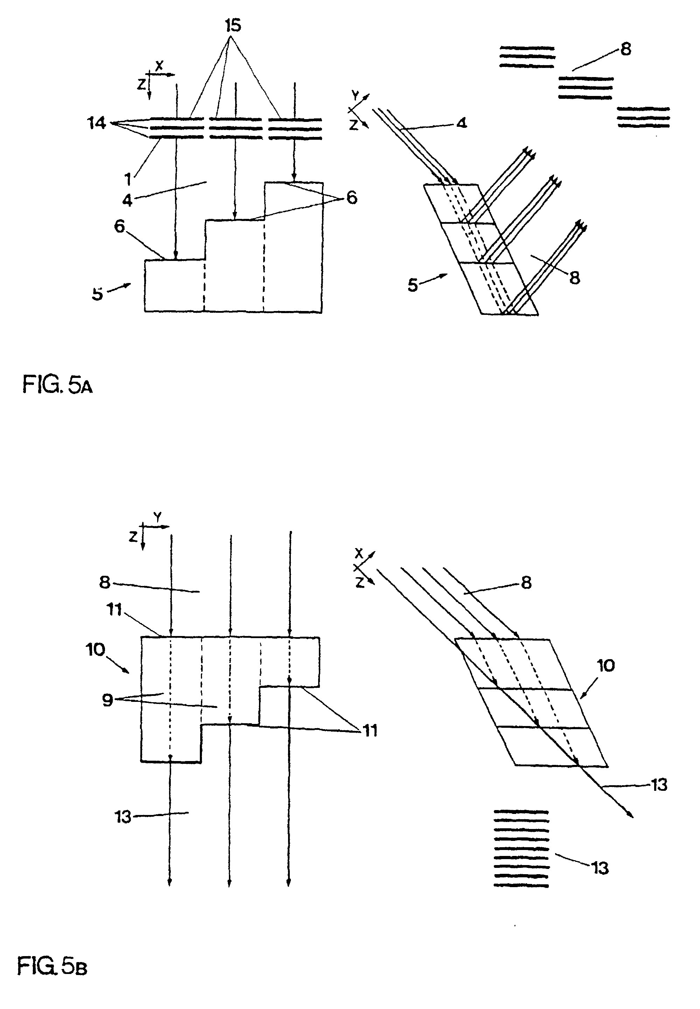

Während vorstehend anhand der Figuren 2 bis 4 verschiedene Ausführungsbeispiele dargestellt sind, bei denen die Strahlungsanteile einer linearen Feldanordnung aus Einzelstrahlungsquellen 1 erläutert wurde, ist in den Figuren 5A und 5B eine Ausführungsform mit einem ersten und einem zweiten Element 5, 10 mit drei Reflexionsflächen 6 (reflektives Element 6) und drei refraktiven Elementen 9 (zweites Element 10) gezeigt, in die die Strahlungsanteile 4 von drei linearen Feldanordnungen 14 mit jeweils drei Einzelstrahlungsquellen 15 einfallen. Die Strahlung der Einzelstrahlungsquellen 15 dieser Feldanordnung wird so in Bezug auf das erste Element 5 gruppiert, daß jeweils die in z-Richtung untereinanderliegenden Einzelstrahlungsquellen 15 jeder in x-Richtung verlaufenden linearen Feldanordnung 14 einem reflektiven Element 6 zugeordnet werden und somit in drei Strahlungsgruppen auf die jeweiligen reflektiven Elemente 6 einfallen. An den einzelnen reflektiven Elementen 6 werden diese Strahlungsgruppen reflektiert, wodurch aufgrund der unterschiedlich langen Ausbreitungswege bis zu den drei reflektiven Elementen 6 die Austrittsstrahlung 8 einen treppenstufenartigen Versatz erfährt. Mit diesem Versatz werden die einzelnen Strahlungsgruppen in die jeweiligen refraktiven Elemente 9 eingestrahlt, die in Figur 5B dargestellt sind, und zwar derart, daß die Strahlung in einer zu der ersten Reflexionsrichtung senkrechten Richtung gebrochen wird, so daß ausgangsseitig der refraktiven Elemente 9 die drei Strahlungsgruppen und damit die neun einzelnen Strahlunganteile untereinander geschoben werden, wie das Strahlungsmuster 13 in der Figur 5B links unten verdeutlicht.

Zu den jeweils erzeugten Strahlungsfeldern ist anzuführen, daß zur Verdeutlichung der jeweiligen Änderung der Ausbreitungsrichtung der Strahlungsflächen die einzelnen Strahlungsquerschnitte mit einem entsprechenden Abstand zueinander dargestellt sind; allerdings können die Strahlen so zusammengeführt werden, daß ein zusammenhängendes Strahlungsfeld in der erwünschten Abbildungsebene erzeugt wird.

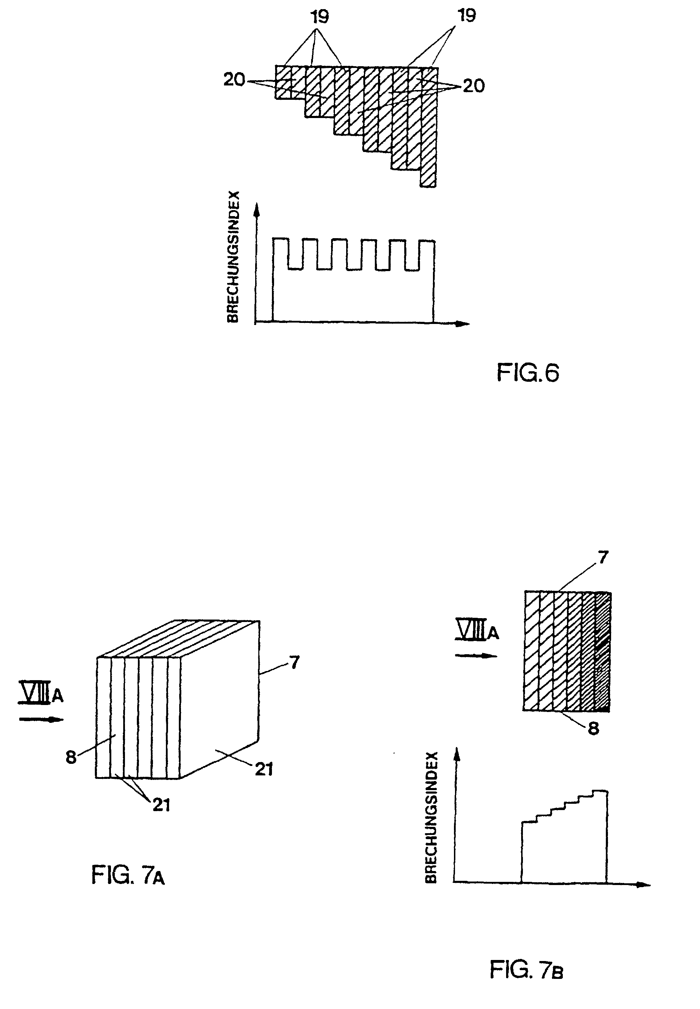

In Figur 6 ist schematisch eine alternative Ausführungsform des zweiten Elements 10 der Figuren 2B und 5B dargestellt, das aus einzelnen Glasplatten 19 (refraktive Elemente) aufgebaut ist. Jeweils benachbarte Glasplatten 19 sind durch eine weitere Glasplatte 20 getrennt, die gegenüber den Glasplatten 19 einen geringeren Brechungsindex aufweisen. Werden die einzelnen Strahlungsanteile in die Glasplatten 19 mit dem höheren Brechungsindex eingekoppelt, so werden sie in der Form eines Wellenleiters darin übertragen und geformt. Eine solche Maßnahme ist insbesondere für Laser-Feldanordnungen, bevorzugt für die Diodenlaser-Feldanordnungen, von Vorteil, die eine geringe Belegungsdichte bzw. einen geringen Füllfaktor haben, da auf diese Weise jedem einzelnen Diodenlaser genau ein refraktives Element zugeordnet werden kann und dadurch, durch den Füllfaktor bedingt, eine Verringerung der Strahlqualität weitgehendst vermieden werden kann.

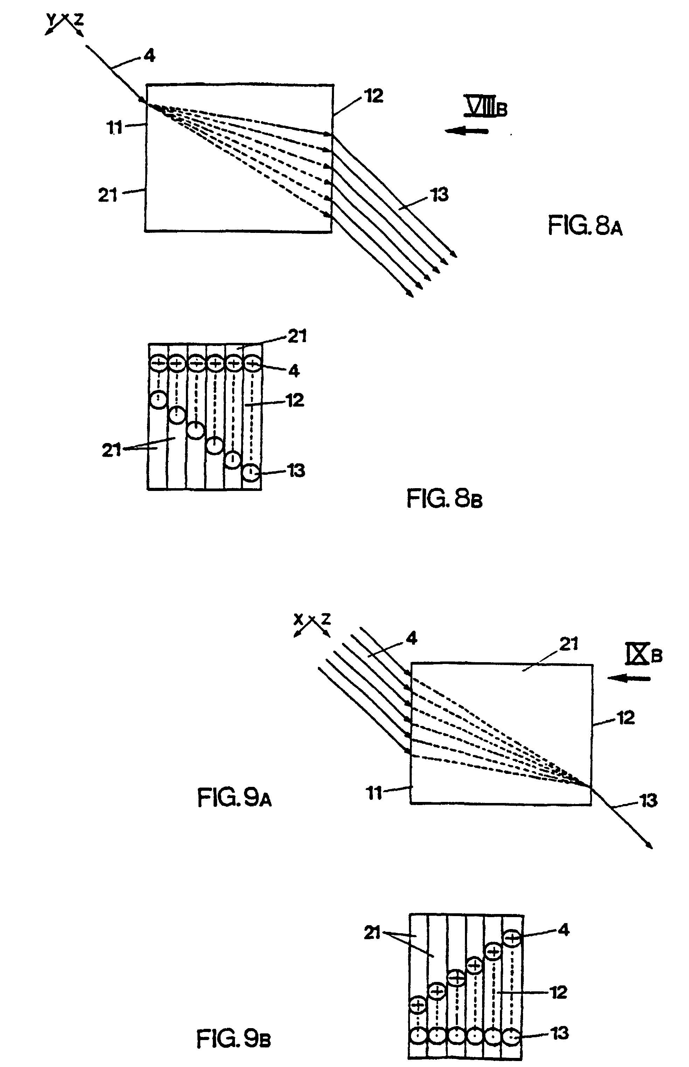

Die Figuren 7A und 7B zeigen eine Anordnung, die aus einzelnen Glasplatten 21 zusammengesetzt sind, die gieiche Außenabmessungen besitzen. Wie anhand der Figur 7B zu erkennen ist, weisen die einzelnen Glasplatten 21 einen unterschiedlichen Brechungsindex auf, wobei der Brechungsindex der linken Platte am niedrigsten ist, während der Brechungsindex der rechten, äußeren Platte 21 am höchsten ist. Die Brechungsindizes sind in etwa gleichen Schritten zwischen den einzelnen Glasplatten 21 erhöht, wie das Diagramm der Figur 7B verdeutlicht. In der Anwendung wird jede Glasplatte 21 als refraktives Element jeweils einer Strahlungsgruppe eines Strahlungsfelds zugeordnet. Jede Strahlungsgruppe fällt auf die jeweilige Strahlungs-Eintrittsfläche 11, wobei es sich um die Stirnflächen der Glasplatten 21 handelt, unter einem Winkel ein, so daß die jeweiligen Teilstrahlen, je nach den Brechungsindizes, unterschiedlich gebrochen werden. Dieser unterschiedliche Strahlungsverlauf innerhalb der Glasplatten 21 ist in der Figur 8A oder 8B verdeutlicht. Mit der Anordnung der einzelnen Glasplatten gemäß der Figuren 7 und 8 wird an der Strahlungs-Austrittsfläche 12 eine Strahlungsverteilung erzeugt, die zueinander versetzt ist, wie die Figuren 8A und 8B erkennen lassen.

In den Figuren 9A und 9B ist eine Anordnung von Glasplatten 21 entsprechend der Figuren 7 und 8A in einer Seitenansicht dargestellt, wobei in dieser Ausführung die einfallende Strahlung 13 von Glasplatte zu Glasplatte 21 einen Versatz zueinander aufweist, wobei dann, aufgrund der abgestuften Brechungsindizes, die Austrittsstrahlen auf gleicher Höhe liegen, wie dies auch in Figur 9B verdeutlicht wird. Die Figur 9A kann beispielsweise als Anschlußfigur zu der Figur 8A eine zusätzliche Transformation liefern.

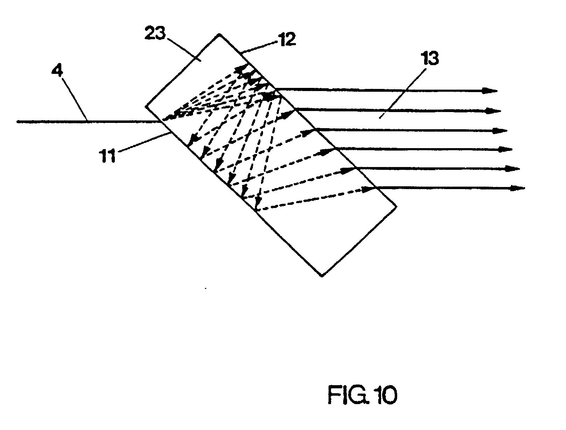

In der Figur 10 ist eine Ausführung in einer seitlichen Ansicht eines weiteren Glasplattenstapels, der aus einzelnen Glaskörpern 23 mit unterschiedlichen Brechungsindizes zusammengesetzt ist, dargestellt. Die auf eine Seitenfläche 11 der einzelnen Glaskörper 23 einfallende Strahlung 4 wird in den jeweiligen Glaskörpern 23 jeweils mehrfach gefaltet und tritt aus den den Eintrittsflächen 11 gegenüberliegenden Austrittsflächen 12 mit einem entsprechenden Versatz aufgrund der unterschiedlichen Brechungsindizes der jeweiligen Glaskörper 23 aus. Die beiden Flächen 11 und 12 können geeignet reflektiv und transmissiv beschichtet sein. Durch diese Mehrfachfaltung werden die Ausbreitungswege innerhalb der Glaskörper 23 verlängert und somit die Versätze der austretenden Strahlungsanteile 13 zueinander trotz geringer Baugröße der Glaskörper 23 vergrößert.

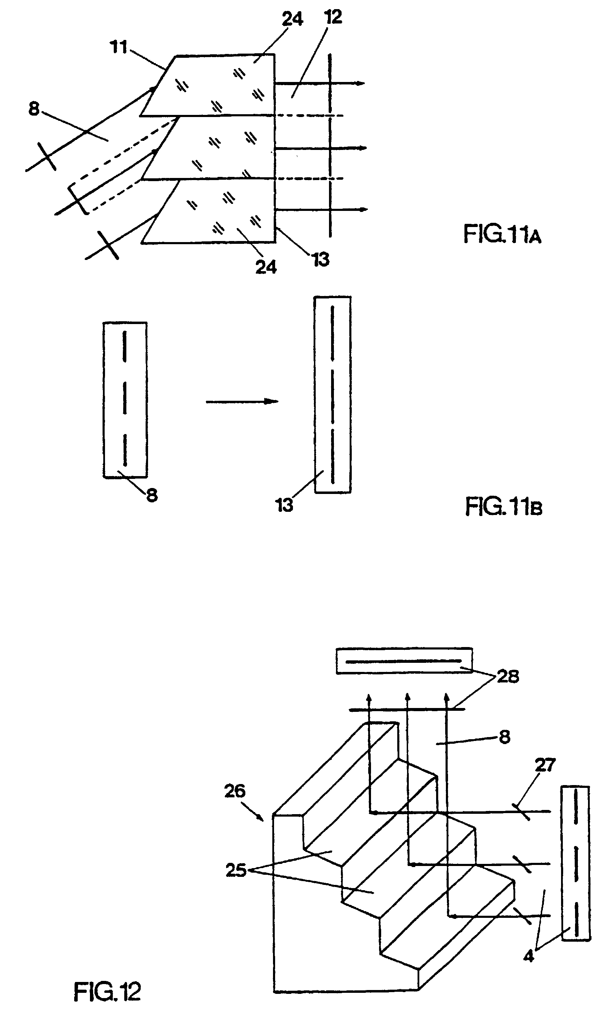

Betrachtet man Feldanordnungen, die aus Diodenlaserarrays aufgebaut sind, beispielsweise in der Form, wie sie in den Figuren 1B und 1E dargestellt ist, so beträgt der Füllfaktor thermisch bedingt etwa 30% bis 50% der durch die Einzelstrahlungsquellen aufgespannten Flächen. Dadurch verringert sich, wie bereits erläutert wurde, die Strahlqualität gegenüber einem theoretischen Fall einer Belegungsdichte von 100%. Um den Füllfaktor zu erhöhen und damit eine hohe Strahlqualität aufrechtzuerhalten, ist eine Anordnung aus refraktiven Elementen 24 von Vorteil, die in Figur 11A dargestellt ist. In diesem schematischen Beispiel sind drei refraktive Elemente 24 gestapelt. Die Eintrittsflächen 11 sind, im Gegensatz zu den weiter vorstehend beschriebenen Ausführungsformen (plattenförmige, refraktive Elemente), abgeschrägt. Die einzelnen, eintretenden Strahlungsanteile 8 sind unter einem Winkel so auf die Strahlungs-Eintrittsflächen 11 gerichtet, daß trotz der geringeren Abmessung der Strahlungsanteile 8 quer zu ihrer Ausbreitungsrichtung die gesamte Strahiungs-Eintrittsfläche 11 des jeweiligen refraktiven Elements 24 ausgeleuchtet wind, wie dies anhand des mittleren refraktiven Elements 24 in Figur 11A angedeutet ist. Auf diese Weise wird auf der Seite der Strahlungs-Austrittsfläche 12 ein höherer Füllfaktor erzeugt, wie deutlicher anhand der Figur 11B dargestellt ist. Eine entsprechende Maßnahme mit reflektiven Elementen ist in Figur 12 schematisch dargestellt. In diesem Beispiel fallen die Strahlungsanteile 4 schräg auf jeweilige reflektive Flächen 25 eines Treppenstufenspiegels 26, wie durch die schrägen Linien 27 an den einfallenden Strahlungsanteilen 4 angedeutet ist, so ein, daß, verglichen mit der Breite der jeweiligen Strahlungsanteile, ein größerer Bereich der reflektiven Flächen 25 bestrahlt wird; hierdurch werden ausgangsseitig die relativen Koordinaten der einzelnen Strahlungsanteile 8 so geändert, daß sie einen Füllfaktor von annähernd 100% aufweisen, wie anhand der durchgezogenen Linie 28 auf der Seite der Austrittsstrahlen 8 angedeutet ist. Eine solche Maßnahme kann zum Beispiel in der Ausführungsform, die in der Figur 2A dargestellt ist, bei dem ersten Element 5 umgesetzt werden, um den Füllfaktor der von den Spiegelflächen reflektierten Strahlen gegenüber den Eintrittsstrahlen zu erhöhen.

Während anhand der Figuren 11 und 12 nur schematisch die Erhöhung des Füllfaktors dargestellt ist, kann durch geeignete Auswahl der Einfallsrichtung der Strahlungsanteile auf die Eintrittsflächen in Bezug auf refraktive Elemente und durch geeignete Auswahl der Lage der reflektiven Flächen 25 gemäß Figur 12 auch zusätzlich der Versatz der austretenden Strahlungsanteile in Bezug auf die eintretenden Strahlungsanteile zueinander so geändert werden, daß eine gewünschte Transformation auftritt, wie dies anhand der Figuren 2 bis 5 vorstehend erläutert wurde.

Da insbesondere in Bezug auf Diodenlasern in bestimmten Anwendungsfällen hohe Leistungsdichten erforderlich sind und hierzu mehrere lineare Diodenlaserfeldanordnungen in der Fastrichtung übereinander gestapelt werden, können für solche Fälle die vorstehenden Maßnahmen zur Erhöhung des Füllfaktors wiederholt in der Fastrichtung vorgenommen werden.

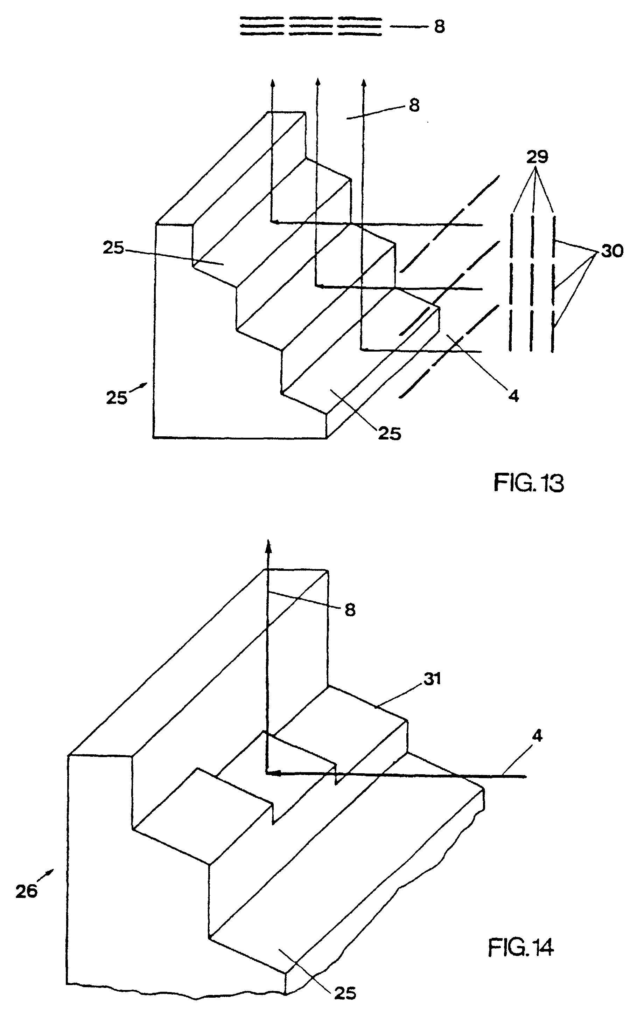

In Figur 13 ist ein schematischer Aufbau eines reflektiven Elements bzw. eines Treppenstufenspiegels 26 mit drei reflektiven Flächen 25 (entsprechend Figur 12) dargestellt. In diesem Fall ist, im Gegensatz zu der Ausführung, wie sie beispielsweise in Figur 12 dargestellt ist, jeder einzelnen reflektiven Fläche 25 eine lineare Feldanordnung 29 zugeordnet, wobei jede lineare Feldanordnung in dieser schematischen Darstellung aus drei Einzelstrahlungsquellen 30, beispielsweise einzelnen Diodenlasern, zusammengesetzt ist. Die Strahlungsanteile jeder linearen Feldanordnung 29 fallen auf jeweils eine reflektive Fläche 25 des Treppenstufenspiegels 26 unter einem vorab ausgewählten Einfallswinkel, wodurch aufgrund der Neigung der Spiegelflächen zu der Einfallsrichtung ausgangsseitig die einzelnen linearen Feldanordnungen 29 dichter zueinander geschoben werden, wie ein Vergleich des jeweiligen Strahlungsfelds 4, 8 einfallsseitig und austrittsseitig des Treppenstufenspiegels 26 zeigt. Mit dieser einfachen Maßnahme kann ebenfalls der Füllfaktor, in der dargestellten Ausführungsform der Figur 13 nur in einer Richtung vorgenommen, erhöht werden.

In Figur 14 ist der obere Teil des Treppenstufenspiegels 26 der Figur 13 vergrößert dargestellt. Während die einzelnen, jeder Stufe zugeordneten reflektiven Flächen 25 des Treppenstufenspiegels 26 der Figur 13 in einer Ebene liegen, ist in der Ausführungsform der Figur 14 beispielhaft eine reflektive Fläche zusätzlich abgestuft, so daß hierdurch die einzelnen Strahlungsanteile einer linearen Feldanordnung 29 aus Einzelstrahlungsquellen 30 auftrittsseitig einen entsprechenden Versatz erhalten.

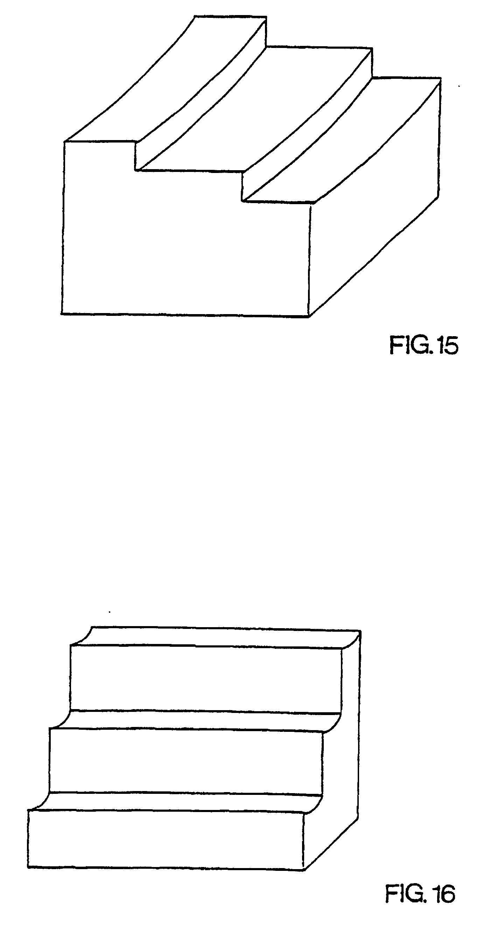

Um die einzelnen Strahlungsanteile, die auf die refraktiven oder reflektiven Elemente, die vorstehend beschrieben sind, auftreffen, zusätzlich zu fokussieren, können die einzelnen Strahlungs-Eintrittsflächen der refraktiven Elemente oder aber die Spiegelflächen der reflektiven Elemente in unterschiedlichen Richtungen konkav gewölbt werden, vorzugsweise zylindermantelsegmentförmig, wie dies die Figuren 15 und 16 zeigen.

Vorstehend wurden verschiedene Ausführungsformen erläutert, um entweder die einzelnen Strahlungsanteile zu gruppieren und umzuordnen oder aber um den Füllfaktor einer Strahlungsgruppe zu erhöhen. Es wird verständlich, daß die jeweiligen Maßnahmen, die zur Umgruppierung und zur Erhöhung des Füllfaktors dargelegt sind, in unterschiedlicher Reihenfolge und in einer unterschiedlichen Anzahl von Schritten vorgenommen werden können.

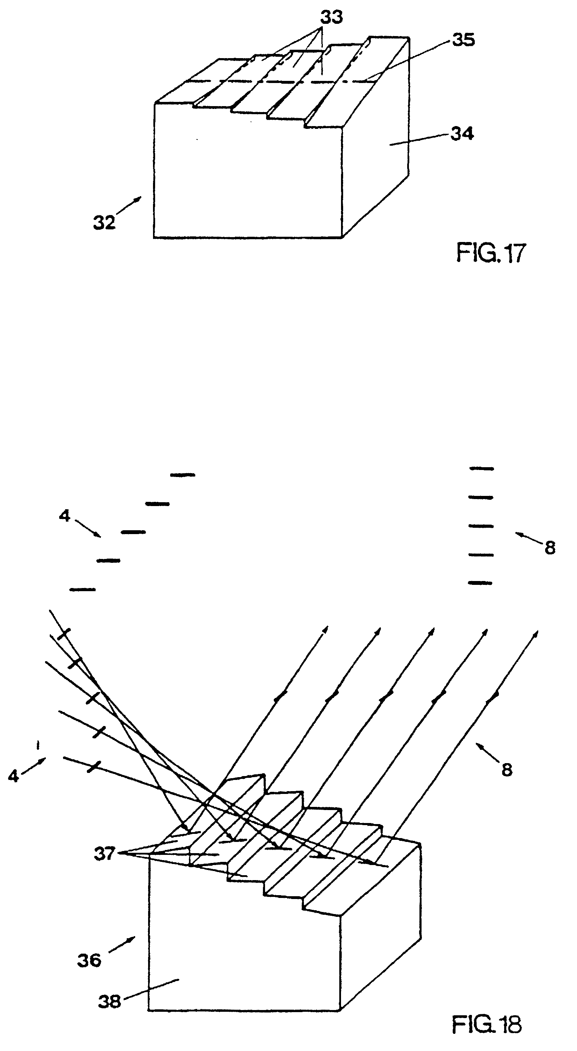

In Figur 17 ist eine weitere Ausführungsform eines Treppenstufenspiegels 32 mit sechs Spiegelflächen 33 dargestellt, wobei jede Spiegelfläche 33 einer Strahlungsgruppe zugeordnet wird. Die einzelnen Spiegelflächen 33 stehen zum einen senkrecht auf einer Ebene, die der Fläche 34 des Treppenstufenspiegels 32 entspricht, zum anderen sind sie um eine Achse 35, die durch eine unterbrochene Linie in Figur 17 angedeutet ist, zueinander um jeweils gleiche Winkel verschwenkt. Aufgrund dieser Maßnahme kann ein doppelter Versatz bzw. eine zweifache Transformation der einzelnen Strahlungsanteile zwischen der Eintrittsseite und auf der Strahlungs-Austrittsseite erreicht werden.

Entsprechend dem Treppenstufenspiegel 32, wie er in Figur 17 dargestellt ist, kann ein refraktiver Körper aufgebaut werden, wobei dann die einzelnen Spiegelflächen 33 des Treppenstufenspiegels 32 der Figur 17 den Eintritts- und/oder Austrittsflächen für die Strahlungsgruppen entsprechen.

Weiterhin können, im Gegensatz zu der Darstellung der Figur 17, die einzelnen Spiegelflächen 33 einen zusätzlichen Versatz derart aufweisen, daß die einzelnen Achsen 35, um die die einzelnen Spiegelflächen 33 zueinander verschwenkt sind, mit Abstand parallel zueinander ausgerichtet sind.

Die Figur 18 zeigt ein Beispiel eines weiteren Treppenstufenspiegels 36 mit sechs Spiegelflächen 37, die jeweils einer Strahlungsgruppe zugeordnet sind. Die einzelnen Treppenstufen-Spiegelflächen 37 stehen senkrecht auf einer Fläche 38, die der einen Seitenfläche des Treppenstufenspiegels 36 in Figur 18 entspricht, sie sind allerdings zueinander, quer zu ihrer Längserstreckung, geringfügig um einen Winkel gekippt, wobei die Längskanten, die auf der Fläche 38 senkrecht stehen, parallel zueinander ausgerichtet sind. Der jeweilige Versatz benachbarter Spiegelflächen 37 ist von rechts nach links jeweils vergrößert. Durch diese Anordnung wird erreicht, daß, ausgehend von einfallenden Strahlungsgruppen, die räumlich getrennt sind und deren Ausbreitungsrichtungen unterschiedlich sind, diese derart reflektiert werden, daß die Strahlungsgruppen in Bezug auf Diodenlaser in Fastrichtung übereinander gestapelt werden und sich in einer gemeinsamen Richtung ausbreiten. Dies gilt analog in Bezug auf Festkörperlaser.

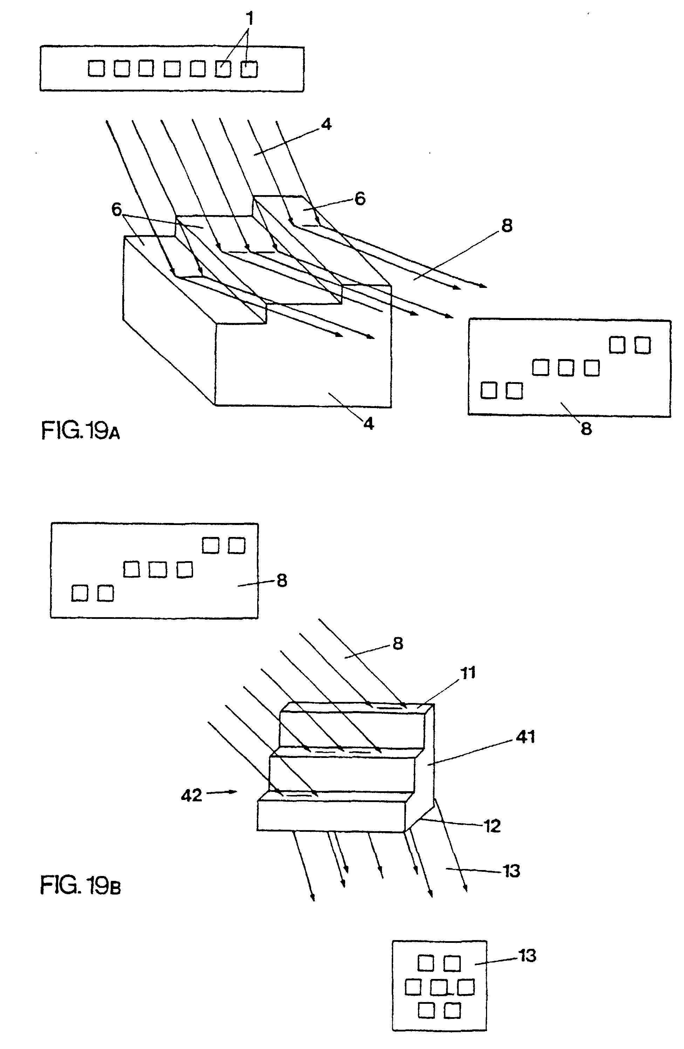

Ein weiteres Ausführungsbeispiel zur Gruppierung und Umorientierung eines Strahlungsfelds, das von sieben linear angeordneten, einzelnen Strahlungsquellen, beispielsweise Einzeldioden 1, abgegeben wird, ist in den Figuren 19A und 19B dargestellt. Gemäß Figur 19A fallen die einzelnen Strahlungsanteile bzw. Strahlungsgruppen 4, die entsprechend der Anzahl der Einzeldioden 1 gruppiert sind, auf einen reflektiven Körper 40, der drei zueinander abgestufte Reflexionsflächen 6 aufweist. Die Strahlungsgruppen 4 sind so gruppiert und diesen Reflexionsflächen 6 zugeordnet, daß an den beiden äußeren Reflexionsflächen 6 jeweils zwei der Strahlungsanteile der Einzeldioden 1 reflektiert werden, während an der mittleren Reflexionsfläche 6 die Strahlungsanteile der entsprechenden drei mittleren Einzeldioden 1 der linearen Feldanordnung eintreten. Aufgrund der unterschiedlichen Abstände der Feldanordnung zu den reflektiven Flächen 6 erhalten die einzelnen Strahlungsanteile an den Reflexionsfläche 6 einen Versatz zueinander, so daß ein Strahlungsmuster entsteht, wie es in Figur 19A rechts angedeutet ist. Diesem Strahlungsmuster werden nun, entsprechend den drei Strahlungsgruppierungen, drei refraktive Elemente 41 eines Elements 42 zugeordnet, wie dies die Figur 19B zeigt. Die einzelnen reflektiven Elemente 41 besitzen einen solchen Versatz, daß die drei Strahlungsgruppen derart unterschiedlich lange Ausbreitungswege durchlaufen, daß sie an den Strahlungs-Austrittsflächen 12 einen Versatz haben und so zusammengeschoben werden, daß ein annähernd kreisförmiges Strahlungsfeld mit zwei-drei-zwei-Strahlungsfeldern untereinanderliegend entsteht.

Anhand dieser Figur wird ersichtlich, daß durch gezielte Umorientierung der einzelnen Strahlungsfelder durch die reflektiven und refraktiven Maßnahmen die Strahlung der Einzeldioden 1, oder aber auch die Strahlung einer Feldanordnung aus einzelnen linearen Einzelstrahlungsquellen, den Anforderungen entsprechend angepaßt werden können.

Weiterhin sollte ersichtlich werden, daß aufgrund der Reflexionen eine Umorientierung der einzelnen Strahlungsanteile erfolgen kann, d.h. diese Strahlungsanteile können um die Achse ihrer Ausbreitungsrichtung gedreht bzw. gespiegelt werden.

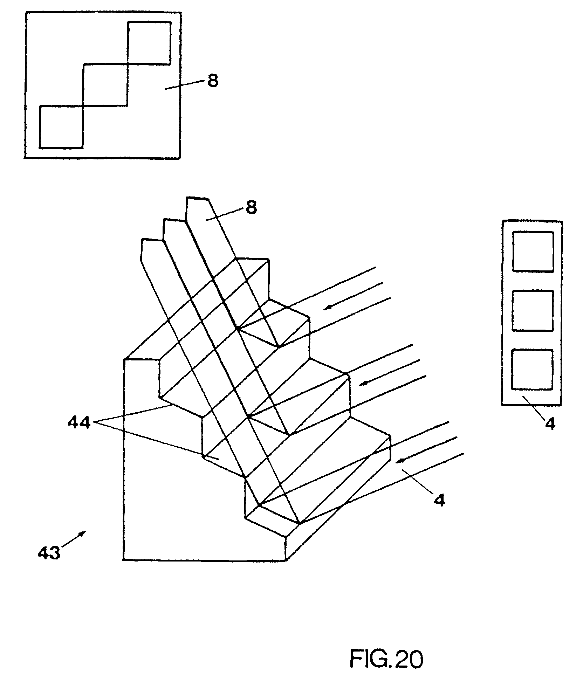

Figur 20 zeigt nochmals ein Ausführungsbeispiel mit einem Treppenstufenspiegel 43, der mit dem Treppenstufenspiegel 26 der Figur 12 vergleichbar ist. In diesem Beispiel wird gezeigt, daß durch die entsprechende Neigung der einzelnen Spiegelflächen 44 derart, daß sie eine Sägezahnform aufweisen, aus einer linearen Strahlungsfeldanordnung, wie sie rechts in Figur 20 dargestellt ist, wo die einzelnen Strahlungsquerschnitte der einzelnen Strahlungsquellen untereinander liegen und einen Abstand zueinander besitzen, eine solche Umorientierung erfolgen kann, daß diese Strahlungsquerschnittsflächen auf einer Diagonalen liegen und aneinander angrenzen, wie dies in Figur 20 links oben gezeigt ist. Mit dieser Anordnung wird ausgangsseitig, verglichen mit der Eintrittsseite, der Füllfaktor erhöht, gleichzeitig aber auch ein Versatz erreicht.

## Patentansprüche

1. Anordnung zur Formung und Führung eines Strahlungsfelds eines oder mehrerer Festkörper- und/oder Halbleiterlaser(s), insbesondere eines Strahlungsfelds eines Arrays bzw. einer Feldanordnung aus mehreren Lasern, mit einer Strahlungstransformationsoptik zur Erzeugung eines definierten Strahlungsfelds, wobei die Optik reflektive und refraktive Elemente (6, 9) aufweist, wobei die Reflexionsflächen der reflektiven Elemente (6) einen Versatz und/oder eine Verkippung derart zueinander aufweisen, daß mindestens zwei Strahlungsgruppen (8) des gemäß einer Vorgabe gruppierten Strahlungsfelds jeweils einem reflektiven Element (6) zugeordnet werden können und daß bei der Reflexion der Strahlungsgruppen (8) an den jeweiligen Reflexionsflächen die relativen Koordinaten der Strahlungsgruppen zueinander in einer ersten Richtung in einer Ebene senkrecht zur Ausbreitungseinrichtung des Strahlungsfelds nach der Reflexion gegenüber den entsprechenden relativen Koordinaten der Strahlungsgruppen (8) vor der Reflexion geändert werden, daß die refraktiven Elemente (9) derart angeordnet sind, daß die reflektierten Strahlungsgruppen (8), gegebenenfalls neu gruppiert, jeweils einem refraktiven Element (9) zugeordnet werden können, und daß bei der Brechung der Strahlungsgruppen (8) an den jeweiligen refraktiven Elementen die relativen Koordinaten der Strahlungsgruppen (8) zueinander in einer Ebene senkrecht zur Ausbreitungsrichtung des Strahlungsfelds nach der Brechung in einer zweiten Richtung mit einer Richtungkomponenten senkrecht zur ersten Richtung gegenüber den entsprechenden relativen Koordinaten der Strahlungsgruppen (8) vor der Brechung geändert wird.

2. Anordnung nach Anspruch 1, **dadurch gekennzeichnet, daß** die Reflexionsflächen (6; 25; 33; 37; 44) jeweils einen unterschiedlichen Abstand zu den ihnen zugeordneten Strahlungs-Austrittsflächen (7) der Laser (3) aufweisen.

3. Anordnung nach Ansprch 1 oder 2, **dadurch gekennzeichnet, daß** die Reflexionsflächen (6; 25; 33; 37;44) ebene Flächenbereiche sind.

4. Anordnung nach Anspruch 1, **dadurch gekennzeichnet, daß** die einzelnen Strahlungsgruppen jeweils unterschiedlich lange Ausbreitungswege in den refraktiven Elementen (20; 21; 23; 24; 42) durchlaufen.

5. Anordnung nach einem der Ansprüche 1 bis 4, **dadurch gekennzeichnet, daß** Austritts- (12) und/oder Eintrittsflächen (11) der refraktiven Elemente (20; 21; 23; 42) in zueinander parallel verlaufenden Ebenen liegen.

6. Anordnung nach einem der Ansprüche 1 bis 5, **dadurch gekennzeichnet, daß** wenigstens ein Teil der refraktiven Elemente (21) unterschiedliche Brechungsindizes zueinander aufweist.

7. Anordnung nach Anspruch 6, **dadurch gekennzeichnet, daß** einzelne benachbarte refraktive Elemente (19) voneinander durch eine Schicht (20) getrennt sind, die einen gegenüber dem angrenzenden refraktiven Element (19) geringeren Brechungsindex aufweist.

8. Anordnung nach einem der Ansprüche 1 bis 7, **dadurch gekennzeichnet, daß** mehrere streifenförmige Strahlungsfelder parallel zueinander angeordnet sind.

9. Anordnung nach Anspruch 8, **dadurch gekennzeichnet, daß** jedes streifenförmige Strahlungsfeld (14) aus einer gleichen Anzahl von Strahlungsgruppen (15) gebildet ist.

## Claims

1. Device for formation and guidance of a radiation field of one or more solid lasers and/or semiconductor lasers, especially a radiation field of an array or a field arrangement consisting of a plurality of lasers, comprising a radiation-transforming optical means for producing a defined radiation field, the optical means having reflective and refractive elements (6, 9), wherein the reflection surfaces of the reflective elements (6) are offset and/or tilted relative to one another such that at least two radiation groups (8) of the radiation field grouped according to a specification can each be assigned to a reflective element (6), and wherein the relative coordinates of the radiation groups upon reflection of the radiation groups (8) on the respective reflection surfaces are changed relative to each other in a first direction in a plane perpendicular to the propagation direction of the radiation field after reflection with respect to the corresponding relative coordinates of the radiation groups (8) before reflection, wherein the refractive elements (9) are arranged in such a way that the reflected radiation groups (8), which are newly grouped if necessary, can each be assigned to a refractive element (9), and wherein the relative coordinates of the radiation groups (8) to each other upon refraction of the radiation groups (8) on the respective refractive elements are changed relative to each other in a plane perpendicular to the propagation direction of the radiation field after refraction in a second direction with a direction component perpendicular to the first direction compared with the corresponding relative coordinates of the radiation groups (8) before refraction.

2. Device according to claim 1, **characterized in that** the reflection surfaces (6; 25; 33; 37; 44) have each a different spacing from their associated radiation exit surfaces (7) of the lasers (3).

3. Device according to claim 1 or claim 2, **characterized in that** the reflection surfaces (6; 25; 33; 37; 44) are planar surface areas.

4. Device according to claim 1, **characterized in that** the individual radiation groups pass each over differently long propagation paths in the refractive elements (20; 21; 23; 24; 42).

5. Device according to any one of claims 1 to 4, **characterized in that** exit surfaces (12) and/or entry surfaces (11) of the refractive elements (20; 21; 23; 42) are positioned in planes extending in parallel with one another.

6. Device according to any one of claims 1 to 5, **characterized in that** at least some of the refractive elements (21) have refractive indices differing from one another.

7. Device according to claim 6, **characterized in that** individual adjacent refractive elements (19) are separated from one another by a layer (20) which has a lower refractive index than the adjacent refractive element (19).

8. Device according to any one of claims 1 to 7, **characterized in that** a plurality of stripe-like radiation fields are arranged in parallel with one another.

9. Device according to claim 8, **characterized in that** each stripe-like radiation field (14) is formed from an identical number of radiation groups (15).

## Revendications

1. Dispositif pour former et guider un champ de rayonnement d'un ou de plusieurs lasers à corps solide et/ou à semiconducteurs, notamment à un champ de rayonnement d'un réseau ou d'un dispositif de champ d'un ou de plusieurs lasers, comportant un système optique de transformation du rayonnement pour produire un champ de rayonnement défini, et dans lequel le système optique comporte des éléments réfléchissants et réfringents (6, 9), et dans lequel les surfaces réfléchissantes des éléments réfléchissants (6) sont décalées et/ou basculées entre elles de telle sorte que deux groupes de rayonnement (8) du champ de rayonnement regroupé conformément à une prescription, peuvent être associés à des éléments réfléchissants respectifs (6) et que lors de la réflexion des groupes de rayonnement (8) sur les surfaces réfléchissantes respectives, les coordonnées relatives des groupes de rayonnement l'un par rapport à l'autre dans une première direction dans un plan perpendiculaire à la direction de propagation du champ de rayonnement après la réflexion sont modifiées par rapport aux coordonnées relatives correspondantes des groupes de rayonnement (8) avant la réflexion, que les éléments réfringents (9) sont disposés de telle sorte que les groupes de rayonnement réfléchis (8), éventuellement nouvellement regroupés, peuvent être associés respectivement à un élément réfringent (9), et que lors de la réfraction des groupes de rayonnement (8) dans les éléments réfringents respectifs, les coordonnées relatives des groupes de rayonnement (8) l'un par rapport à l'autre dans un plan perpendiculaire à la direction de propagation du champ de rayonnement après la réfraction dans une seconde direction avec une composante directionnelle perpendiculaire à la première direction sont modifiées par rapport aux coordonnées relatives correspondantes des groupes de rayonnement (8) avant la réfraction.

2. Dispositif selon la revendication 1, **caractérisé en ce que** les surfaces réfléchissantes (6; 25; 33; 37; 44) sont situées respectivement à des distances différentes des surfaces de sortie du rayonnement (7), qui leur sont associées, des lasers (3).

3. Dispositif selon la revendication 1 ou 2, **caractérisé en ce que** les surfaces réfléchissantes (6; 25; 33; 37; 44) sont des parties de surface planes.

4. Dispositif selon la revendication 1, **caractérisé en ce que** les différents groupes de rayonnement parcourent des trajets de propagation respectifs ayant des longueurs différentes dans les éléments réfringents (20; 21; 23; 24; 42).

5. Dispositif selon l'une des revendications 1 à 4, **caractérisé en ce que** les surfaces de sortie (12) et/ou les surfaces d'entrée (11) des éléments réfringents (20; 21; 23; 42) sont situés dans des plans parallèles entre eux.

6. Dispositif selon l'une des revendications 1 à 5, **caractérisé en ce qu'**au moins une partie des éléments réfringents (21) possèdent des indices de réfraction différents les uns des autres.

7. Dispositif selon la revendication 6, **caractérisé en ce que** différents éléments réfringents individuels (19) sont séparés les uns des autres par une couche (20) qui possède un indice de réfraction inférieur à celui de l'autre élément réfringent contigu (19).

8. Dispositif selon l'une des revendications 1 à 7, **caractérisé en ce que** plusieurs champs de rayonnement en forme de bandes sont disposés parallèlement entre eux.

9. Dispositif selon la revendication 8, **caractérisé en ce que** chaque champ de rayonnement en forme de bande (14) est formé par un nombre identique de groupes de rayonnement (15).
